# EUROPEAN PATENT APPLICATION

(11) **EP 4 535 430 A1**
(43) Date of publication of application: **09.04.2025**
(21) Application number: 23815853.9
(22) Date of filing: 22.05.2023
(51) Int. Cl.: H01L 31/0232, G01J 1/02, G02B 5/20, G02B 5/22, G02B 5/28, H01L 27/146, H01L 31/10

(54) **PHOTODETECTOR ELEMENT, IMAGE SENSOR, AND METHOD FOR MANUFACTURING PHOTODETECTOR ELEMENT**

(30) Priority: 01.06.2022 JP 2022089620
(71) Applicant: FUJIFILM Corporation, Tokyo 106-8620 (JP)
(72) Inventor: GOTO, Takashi, Haibara-gun, Shizuoka 421-0396 (JP); MIYATA, Tetsushi, Haibara-gun, Shizuoka 421-0396 (JP)
(74) Representative: HGF
(86) International application number: PCT/JP2023/018903
(87) International publication number: WO 2023/234094

(57) **Abstract**

Provided is a photodetector element having a photoelectric conversion element 10, an optical filter 30 provided on a light incident side of the photoelectric conversion element 10, and an interlayer 20 provided between the photoelectric conversion element 10 and the optical filter 30, in which the photoelectric conversion element 10 has a quantum dot layer 13, a first electrode 11, and a second electrode 12, the optical filter 30 has predetermined spectral characteristics, and the interlayer 20 includes at least one kind of atom selected from the group consisting of Si, Al, Zr, Sn, Zn, Ce, and Hf, or includes a paraxylene polymer, or has a water vapor permeability as determined by a method in accordance with JIS K 7129 of 1 × 10⁻⁴ g/m²/day or less. Provided also are an image sensor and a method for manufacturing a photodetector element.

## Description

### BACKGROUND OF THE INVENTION

### 1. Field of the Invention

The present invention relates to a photodetector element comprising a photoelectric conversion element having a quantum dot layer, an image sensor, and a method for manufacturing a photodetector element.

### 2. Description of the Related Art

A substance reduced to about several nm to ten and several nm exhibits physical properties different from those in a bulk state. Such a phenomenon is called a quantum size effect or the like, and a substance in which such an effect is exhibited is called a quantum dot. A change in size of the quantum dot makes it possible to adjust a band gap thereof (a light absorption wavelength or a luminescence wavelength).

In recent years, research on the quantum dot has advanced. For example, a use of the quantum dot as a material for a photoelectric conversion element is being studied.

WO2020/241535A describes an optical sensor in which an optical filter such as an infrared transmitting filter is laminated on a photoelectric conversion element having a quantum dot layer including quantum dots having a maximal absorption wavelength in an infrared range of 800 nm or more.

### SUMMARY OF THE INVENTION

Generally, an optical filter such as an infrared transmitting filter is formed by applying a composition for forming an optical filter onto a support. The present inventors have conducted intensive studies on a photodetector element comprising a photoelectric conversion element using quantum dots, and have thus found that in a case where an optical filter such as an infrared transmitting filter is formed on a photoelectric conversion element using quantum dots, a dark current of a photodetector element after the formation of the optical filter tends to increase more easily, as compared with the state before the formation of the optical filter. Here, the dark current is a current that flows in a case of not being irradiated with light. In a case where the dark current of the photodetector element is large, a signal-to-noise ratio is likely to be small.

Therefore, an object of the present invention is to provide a photodetector element in which a dark current is suppressed. In addition, another object of the present invention is to provide an image sensor and a method for manufacturing a photodetector element.

The present invention provides the following aspects.
<1> A photodetector element comprising:
   a photoelectric conversion element;
   an optical filter provided on a light incident side of the photoelectric conversion element; and
   an interlayer provided between the photoelectric conversion element and the optical filter,
   in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
   in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
   the interlayer includes at least one kind of atom selected from the group consisting of Si, Al, Zr, Sn, Zn, Ce, and Hf, or includes a paraxylene polymer.
<2> A photodetector element comprising:
   a photoelectric conversion element;
   an optical filter provided on a light incident side of the photoelectric conversion element; and
   an interlayer provided between the photoelectric conversion element and the optical filter,
   in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
   in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
   the interlayer has a water vapor permeability as determined by a method in accordance with JIS K 7129 of 1 × 10⁻⁴ g/m²/day or less.
<3> The photodetector element according to <1> or <2>,
   in which a ratio of a thickness of the interlayer to a thickness of the quantum dot layer is 0.01 to 1.
<4> The photodetector element according to any one of <1> to <3>,
   in which the interlayer includes a film formed with at least one selected from the group consisting of silicon oxide, silicon oxynitride, silicon nitride, zirconium oxide, zinc oxide, cerium oxide, aluminum oxide, and hafnium oxide by an atomic layer deposition method.
<5> The photodetector element according to any one of <1> to <4>,
   in which a ratio of a thickness of the optical filter to a thickness of the quantum dot layer is 0.1 to 100.
<6> The photodetector element according to any one of <1> to <5>,
   in which the quantum dot layer has a higher absorbance at a wavelength of 550 nm than that at a wavelength of 1,450 nm.
<7> The photodetector element according to any one of <1> to <6>,
   in which the quantum dot layer includes quantum dots including at least one kind of atom selected from the group consisting of Ga, As, Se, In, Sb, Te, and Bi.
<8> The photodetector element according to any one of <1> to <7>,
   in which the quantum dot layer includes the quantum dots and ligands coordinated to the quantum dots, and
   the ligands include an inorganic ligand including a halogen atom.
<9> The photodetector element according to any one of <1> to <8>,
   in which a thickness of the quantum dot layer is 200 to 700 nm.
<10> The photodetector element according to any one of <1> to <9>,
   in which the maximal absorption wavelength of the quantum dot layer is present in a wavelength range of 1,300 to 1,500 nm.
<11> The photodetector element according to any one of <1> to <10>,
   in which the first electrode includes indium tin oxide.
<12> An image sensor comprising:
   the photodetector element according to any one of <1> to <11>.
<13> The image sensor according to <12>,
   in which the image sensor is an infrared sensor.
<14> A method for manufacturing a photodetector element including a photoelectric conversion element, an optical filter provided on a light incident side of the photoelectric conversion element, and an interlayer provided between the photoelectric conversion element and the optical filter, the method comprising:
   a step of applying a composition for forming an optical filter onto the interlayer to form a composition layer for forming an optical filter, and exposing the composition layer for forming an optical filter two or more times to form the optical filter,
   in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
   in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
   the interlayer includes at least one kind of atom selected from the group consisting of Si, Al, Zr, Sn, Zn, Ce, and Hf, or includes a paraxylene polymer.
<15> A method for manufacturing a photodetector element including a photoelectric conversion element, an optical filter provided on a light incident side of the photoelectric conversion element, and an interlayer provided between the photoelectric conversion element and the optical filter, the method comprising:
   a step of applying a composition for forming an optical filter onto the interlayer to form a composition layer for forming an optical filter, and exposing the composition layer for forming an optical filter two or more times to form the optical filter,
   in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
   in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
   the interlayer has a water vapor permeability as determined by a method in accordance with JIS K 7129 of 1 × 10⁻⁴ g/m²/day or less.

According to the present invention, it is possible to provide a photodetector element in which a dark current is suppressed. In addition, the present invention can provide an image sensor and a method for manufacturing a photodetector element.

### BRIEF DESCRIPTION OF THE DRAWINGS

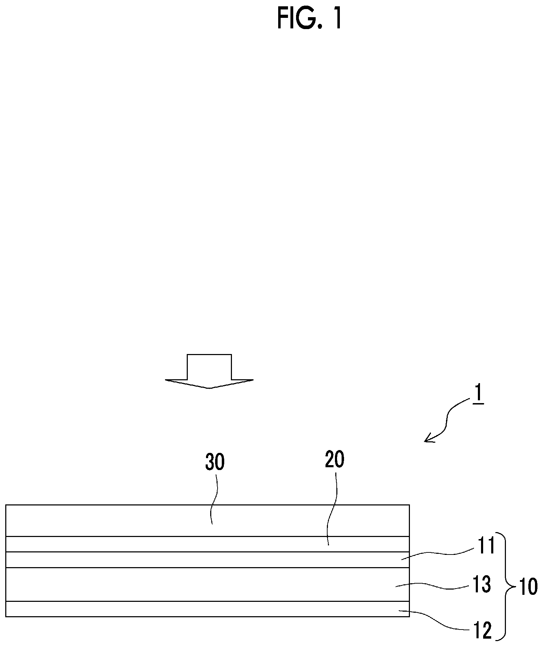

Fig. 1 is a schematic view showing an embodiment of a photodetector element of an embodiment of the present invention.

### DESCRIPTION OF THE PREFERRED EMBODIMENTS

Hereinafter, the details of the present invention will be described.

In the present specification, a numerical range expressed using "to" means a range that includes the preceding and succeeding numerical values of "to" as the lower limit value and the upper limit value, respectively.

In the present specification, a term "step" not only means an independent step but also includes a step which is not clearly distinguished from other steps in a case where an intended action of the step is accomplished.

### <Photodetector Element>

A photodetector element of a first aspect of the present invention has a photoelectric conversion element,
an optical filter provided on a light incident side of the photoelectric conversion element, and
an interlayer provided between the photoelectric conversion element and the optical filter,
in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer includes at least one kind of atom selected from the group consisting of Si, Al, Zr, Sn, Zn, Ce, and Hf, or includes a paraxylene polymer.

A photodetector element of a second aspect of the present invention has a photoelectric conversion element,
an optical filter provided on a light incident side of the photoelectric conversion element, and
an interlayer provided between the photoelectric conversion element and the optical filter,
in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer has a water vapor permeability as determined by a method in accordance with JIS K 7129 of 1 × 10⁻⁴ g/m²/day or less.

Hereinafter, the photodetector element of the first aspect and the photodetector element of the second aspect will be collectively referred to as the photodetector element of the embodiment of the present invention.

Since the photodetector element of the first aspect has an interlayer between the photoelectric conversion element and the optical filter, the interlayer including at least one kind of atom selected from the group consisting of Si, Al, Zr, Sn, Zn, Ce and Hf, or including a paraxylene polymer, a damage to the quantum dot layer during the formation of the optical filter, and the like can be suppressed though the interlayer, and as a result, an increase in dark current can be suppressed. Furthermore, a fluctuation in external quantum efficiency before and after the formation of the optical filter can be suppressed. Therefore, a high-sensitivity photodetector element can be obtained.

Since the photodetector element of the second aspect has an interlayer having a water vapor transmittance of 1 × 10⁻⁴ g/m²/day as determined by a method in accordance with JIS K 7129 between the photoelectric conversion element and the optical filter, a damage to the quantum dot layer during the formation of the optical filter, and the like can be suppressed by the interlayer, and as a result, an increase in dark current can be suppressed. Furthermore, a fluctuation in external quantum efficiency before and after the formation of the optical filter can be suppressed. Therefore, a high-sensitivity photodetector element can be obtained.

In addition, by configuring the photodetector element of the embodiment of the present invention (the photodetector element of the first aspect and the photodetector element of the second aspect) to have an optical filter, in which a maximum value of a transmittance of light in a wavelength range of 400 to 700 nm is 20% or less, and a maximum value of a transmittance of light in a range of the maximal absorption wavelength of the quantum dot layer ± 100 nm is 60% or more, provided on a light incident side of a photoelectric conversion element having a quantum dot layer, in which a maximal absorption wavelength of an absorbance is present in a wavelength range of 900 to 1,700 nm, the photoelectric conversion element can receive infrared rays at a target wavelength with little noise derived from sunlight. Therefore, the photodetector element of the embodiment of the present invention can improve an accuracy of sensing using infrared rays.

In addition, the photodetector element of the embodiment of the present invention uses quantum dots in the photoelectric conversion element, but the absorption wavelength can be adjusted by adjusting a size or the like of the quantum dots. For example, the absorption wavelength can be shifted to the long wavelength side by increasing the size of the quantum dots, and the absorption wavelength can be shifted to the short wavelength side by reducing the size of the quantum dots. Therefore, it is possible to easily make a change, an adjustment, and the like of the spectral design of the photodetector element, and it is easy to change the design according to a use or a purpose of the photodetector element.

The photodetector element of the embodiment of the present invention will be described in more detail with reference to the drawings. Furthermore, an arrow in the figure represents the incidence ray on the photodetector element.

A photodetector element 1 shown in Fig. 1 is a schematic view showing an embodiment of the photodetector element of the embodiment of the present invention. In the photodetector element 1, an interlayer 20 is provided on a light incident side of the photoelectric conversion element 10. Furthermore, an optical filter 30 is provided on the interlayer 20.

### <<Photoelectric Conversion Element 10>>

The photoelectric conversion element 10 has a quantum dot layer 13 including quantum dots and having a maximal absorption wavelength of an absorbance present in a wavelength range of 900 to 1,700 nm, a first electrode 11 provided on a light incident side of the quantum dot layer 13, and a second electrode 12 provided on a surface of the quantum dot layer 13 on a side opposite to a side on which the first electrode 11 is provided. In the photodetector element of the embodiment of the present invention, the first electrode 11 side of the photoelectric conversion element is the light incident side.

### (First Electrode 11)

The first electrode 11 is provided on a light incident side of the quantum dot layer 13. The first electrode 11 is preferably a transparent electrode formed of a conductive material that is substantially transparent with respect to the wavelength of target light to be detected by the photodetector element. Furthermore, in the present specification, the description of "substantially transparent" means that the transmittance of light is 50% or more, preferably 60% or more, and particularly preferably 80% or more. Examples of a material for the first electrode include a metal, an alloy, a metal oxide, a metal nitride, a metal boride, and an organic conductive compound. Specific examples thereof include tin oxide, zinc oxide, indium oxide, indium tungsten oxide, indium zinc oxide (IZO), indium tin oxide (ITO), and a fluorine-doped tin oxide (FTO).

It is preferable that the first electrode 11 includes indium tin oxide from the viewpoint that the adhesiveness to the interlayer 20 is excellent. In particular, in a case where the interlayer 20 is composed of a film including at least one selected from the group consisting of silicon oxide, silicon oxynitride, silicon nitride, zirconium oxide, zinc oxide, cerium oxide, aluminum oxide, hafnium oxide, and a paraxylene polymer, the effects can be obtained more remarkably.

The first electrode 11 can be formed by a vacuum vapor deposition method, a physical vapor phase growth method (PVD method) such as sputtering, a chemical vapor phase growth method (CVD method), or the like.

The first electrode 11 is preferably a film formed of indium tin oxide by sputtering from the viewpoint that the adhesiveness to the interlayer 20 is excellent.

A thickness of the first electrode 11 is preferably 10 to 100,000 nm. A lower limit thereof is preferably 30 nm or more, and more preferably 50 nm or more. An upper limit of the thickness is preferably 10,000 nm or less, and more preferably 1,000 nm or less. In the present specification, a thickness of each layer can be measured by observing a cross-section of the photodetector element using a scanning electron microscope or the like.

### (Second Electrode 12)

The second electrode 12 is provided on a surface of the quantum dot layer 13 on a side opposite to a side on which the first electrode 11 is provided. The second electrode 12 may be provided on a surface of the quantum dot layer 13 on a side opposite to a side on which the first electrode 11 is provided. That is, with regard to a positional relationship between the first electrode 11 and the second electrode 12, the second electrode 12 is not limited to an aspect in which the second electrode 12 is provided at a position facing the first electrode 11 (an aspect in which the second electrode 12 is provided on an optical path of the first electrode 11), and the second electrode 12 may be provided at a position deviated from the optical path of the first electrode 11.

The second electrode 12 may or may not be transparent with respect to the wavelength of the target light to be detected by the photodetector element. Examples of a material for the second electrode 12 include a metal, an alloy, a metal oxide, a metal nitride, a metal boride, an organic conductive compound, and a carbon material (fullerene, carbon nanotubes, graphite, graphene, or the like).

The second electrode 12 is preferably composed of a metal material including at least one metal atom selected from Ag, Au, Pt, Ir, Pd, Cu, Pb, Sn, Zn, Ti, W, Mo, Ta, Ge, Ni, Al, Cr, and In.

The second electrode 12 can be formed by a vacuum vapor deposition method, a physical vapor phase growth method (PVD method) such as sputtering, a chemical vapor phase growth method (CVD method), or the like.

A thickness of the second electrode 12 is preferably 10 to 100,000 nm. A lower limit thereof is preferably 30 nm or more, and more preferably 50 nm or more. An upper limit of the thickness is preferably 10,000 nm or less, and more preferably 1,000 nm or less.

### (Quantum Dot Layer 13)

The quantum dot layer 13 is disposed between the first electrode 11 and the second electrode 13. The quantum dot layer 13 is a layer including quantum dots. The quantum dot is preferably a semiconductor particle including a metal atom. Furthermore, in the present specification, the metal atom also includes a metalloid atom typified by an Si atom. In addition, the "semiconductor" in the present specification means a substance having a specific resistance value of 10⁻² Ωcm or more and 10⁸ Ωcm or less.

Examples of the quantum dot material constituting the quantum dot include a nanoparticle (a particle having a size of 0.5 nm or more and less than 100 nm) of a general semiconductor crystal [a) a Group IV semiconductor, b) a compound semiconductor of a Group IV to IV element, a Group III to V element, or a Group II to VI element, or c) a compound semiconductor consisting of a combination of three or more of a Group II element, a Group III element, a Group IV element, a Group V element, and a Group VI element].

The quantum dot is preferably a quantum dot including at least one kind of atom selected from the group consisting of Ga, Ge, As, Se, In, Sn, Sb, Te, Pb, Bi, Ag, Cu, and Hg, and more preferably a quantum dot including at least one kind of atom selected from the group consisting of Ga, As, Se, In, Sb, Te, and Bi. In addition, it is also preferable that the quantum dot includes a Pb atom.

Specific examples of the quantum dot material constituting the quantum dot include semiconductor materials having a relatively narrow band gap, such as PbS, PbSe, PbSeS, InN, Ge, GeO₂, InAs, InGaAs, CuInS, CuInSe, CuInGaSe, InSb, InP, HgTe, HgCdTe, Ag₂S, Ag₂Se, Ag₂Te, SnS, SnSe, SnTe, Si, InP, AgBiS₂, AgBiSTe, and lead perovskite. For a reason that the absorption coefficient of light in the infrared range is large, the lifetime of photocurrent is long, and the carrier mobility is large, the quantum dot is more preferably PbS, InAs, InSb, InP, Ge, GeO₂, AgBiS₂, or AgBiSTe.

The maximal absorption wavelength of the quantum dot is preferably present in a wavelength range of 900 to 1,700 nm, and more preferably present in a wavelength range of 1,300 to 1,500 nm. In a case where the maximal absorption wavelength of the quantum dot is present in the range, a quantum dot layer having a higher sensitivity to light at a wavelength in the infrared range can be formed.

A band gap of the quantum dot is preferably 1.35 eV or less, more preferably 1.1 eV or less, and still more preferably 1.0 eV or less. A lower limit value of the band gap of the quantum dot is not particularly limited, but can be 0.5 eV or more. In a case where the band gap of the quantum dot is 1.35 eV, a quantum dot layer having a higher sensitivity to light at a wavelength in the infrared range can be formed. The band gap of the quantum dot can be calculated from the energy at the maximal absorption wavelength in an absorption spectrum obtained from light absorption measurement in a range from the visible range to the infrared range, by using an ultraviolet-visible-near infrared spectrophotometer. In addition, the band gap can be determined from a Tauc plot as described in JP5949567B in a case of a quantum dot having no maximal absorption wavelength.

An average particle diameter of the quantum dots is preferably 1 to 20 nm. A lower limit value of the average particle diameter of the quantum dots is preferably 2 nm or more, and more preferably 3 nm or more. An upper limit value of the average particle diameter of the quantum dots is preferably 15 nm or less, and more preferably 10 nm or less. In a case where the average particle diameter of the quantum dots is in the range, a quantum dot layer having a higher sensitivity to light at a wavelength in the infrared range can be formed. Furthermore, in the present specification, the value of the average particle diameter of the quantum dots is an average value of the particle diameters of ten quantum dots which are randomly selected. A transmission electron microscope may be used for measuring the particle diameter of the quantum dots.

The quantum dot layer 13 preferably includes quantum dots and ligands coordinated to the quantum dots. The ligand may be an organic ligand or an inorganic ligand.

The inorganic ligand preferably includes an inorganic ligand including a halogen atom. The inorganic ligand including a halogen atom is easily coordinated to the quantum dot and can suppress the occurrence of surface defects.

Examples of the halogen atom included in the inorganic ligand including a halogen atom include F, Cl, Br, and I, and Br is preferable.

The inorganic ligand including a halogen atom preferably includes the atom included in the quantum dot. For example, in a case where the quantum dot has InSb as a mother crystal, it is preferable that the inorganic ligand including a halogen atom includes at least one kind of atom selected from In and Sb, and more preferably includes the In atom.

Specific examples of the inorganic ligand including a halogen atom include zinc iodide, zinc bromide, zinc chloride, indium iodide, indium bromide, indium chloride, cadmium iodide, cadmium bromide, and cadmium chloride, gallium iodide, gallium bromide, and gallium chloride.

Furthermore, in the inorganic ligand including a halogen atom, the halogen ion may be dissociated from the above-described ligand, and the halogen ion may be coordinated to a surface of the quantum dot. In addition, a moiety other than the halogen atom of the above-described ligand may also be coordinated to a surface of the quantum dot. To explain with a specific example, in a case of indium bromide, the indium bromide may be coordinated to the surface of the quantum dot, or the bromide ion or the indium ion may be coordinated to the surface of the quantum dot.

The quantum dot layer 13 may include an inorganic ligand including no halogen atom. Specific examples of the inorganic ligand including no halogen element include ammonium sulfide.

The organic ligand may be a monodentate organic ligand having one coordination moiety **or** may be a multidentate organic ligand having two or more coordination moieties. Examples of the coordination moiety included in the organic ligand include a thiol group, an amino group, a hydroxy group, a carboxy group, a sulfo group, a phospho group, and a phosphonic acid group.

Examples of the multidentate ligand include a ligand represented by any of Formulae (A) to (C).

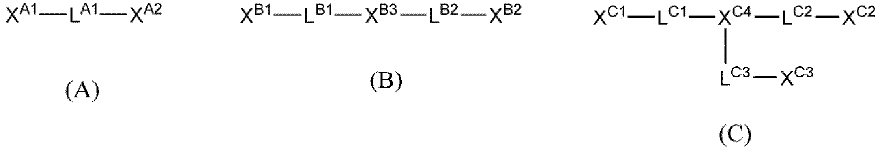

In Formula (A), X^{A1} and X^{A2} each independently represent a thiol group, an amino group, a hydroxy group, a carboxy group, a sulfo group, a phospho group, or a phosphonic acid group, and L^{A1} represents a hydrocarbon group.

In Formula (B), X^{B1} and X^{B2} each independently represent a thiol group, an amino group, a hydroxy group, a carboxy group, a sulfo group, a phospho group, or a phosphonic acid group,
X^{B3} represents S, O, or NH, and
L^{B1} and L^{B2} each independently represent a hydrocarbon group.

In Formula (C), X^{C1} to X^{C3} each independently represent a thiol group, an amino group, a hydroxy group, a carboxy group, a sulfo group, a phospho group, or a phosphonic acid group,
X^{C4} represents N, and
L^{C1} to L^{C3} each independently represent a hydrocarbon group.

The amino group represented by X^{A1} X^{A2}, X^{B1}, X^{B2}, X^{C1}, X^{C2}, or X^{C3} is not limited to - NH₂ and includes a substituted amino group and a cyclic amino group as well. Examples of the substituted amino group include a monoalkylamino group, a dialkylamino group, a monoarylamino group, a diarylamino group, and an alkylarylamino group. The amino group represented by these groups is preferably -NH₂, a monoalkylamino group, or a dialkylamino group, and more preferably -NH₂.

The hydrocarbon group represented by L^{A1}, L^{B1}, L^{B2}, L^{C1}, L^{C2}, or L^{C3} is preferably an aliphatic hydrocarbon group or a group including an aromatic ring, and more preferably the aliphatic hydrocarbon group. The aliphatic hydrocarbon group may be a saturated aliphatic hydrocarbon group or may be an unsaturated aliphatic hydrocarbon group. The hydrocarbon group preferably has 1 to 20 carbon atoms. An upper limit of the number of carbon atoms is preferably 10 or less, more preferably 6 or less, and still more preferably 3 or less. Specific examples of the hydrocarbon group include an alkylene group, an alkenylene group, an alkynylene group, and an arylene group.

Examples of the alkylene group include a linear alkylene group, a branched alkylene group, and a cyclic alkylene group. The linear alkylene group or the branched alkylene group is preferable, and the linear alkylene group is more preferable. Examples of the alkenylene group include a linear alkenylene group, a branched alkenylene group, and a cyclic alkenylene group. The linear alkenylene group or the branched alkenylene group is preferable, and the linear alkenylene group is more preferable. Examples of the alkynylene group include a linear alkynylene group and a branched alkynylene group, and the linear alkynylene group is preferable. The arylene group may be a monocyclic ring or may be a polycyclic ring. The monocyclic arylene group is preferable. Specific examples of the arylene group include a phenylene group and a naphthylene group, and the phenylene group is preferable. The alkylene group, the alkenylene group, the alkynylene group, and the arylene group may further have a substituent. The substituent is preferably a group having 1 or more and 10 or less atoms. Preferred specific examples of the group having 1 or more and 10 or less of atoms include an alkyl group having 1 to 3 carbon atoms [a methyl group, an ethyl group, a propyl group, and an isopropyl group], an alkenyl group having 2 or 3 carbon atoms [an ethenyl group and a propenyl group], an alkynyl group having 2 to 4 carbon atoms [an ethynyl group, a propynyl group, and the like], a cyclopropyl group, an alkoxy group having 1 or 2 carbon atoms [a methoxy group and an ethoxy group], an acyl group having 2 or 3 carbon atoms [an acetyl group and a propionyl group], an alkoxycarbonyl group having 2 or 3 carbon atoms [a methoxycarbonyl group and an ethoxycarbonyl group], an acyloxy group having 2 carbon atoms [an acetyloxy group], an acylamino group having 2 carbon atoms [an acetylamino group], a hydroxyalkyl group having 1 to 3 carbon atoms [a hydroxymethyl group, a hydroxyethyl group, and a hydroxypropyl group], an aldehyde group, a hydroxy group, a carboxy group, a sulfo group, a phospho group, a carbamoyl group, a cyano group, an isocyanate group, a thiol group, a nitro group, a nitroxy group, an isothiocyanate group, a cyanate group, a thiocyanate group, an acetoxy group, an acetamide group, a formyl group, a formyloxy group, a formamide group, a sulfamino group, a sulfino group, a sulfamoyl group, a phosphono group, an acetyl group, a halogen atom, and an alkali metal atom.

In Formula (A), X^{A1} and X^{A2} are separated by L^{A1}, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (B), X^{B1} and X^{B3} are separated by L^{B1}, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, X^{B2} and X^{B3} are separated by L^{B2}, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (C), X^{C1} and X^{C4} are separated by L^{C1}, preferably by 1 to 10 atoms, more preferably by 1 to 6 atoms, still more preferably by 1 to 4 atoms, even still more preferably by 1 to 3 atoms, and particularly preferably by 1 or 2 atoms. Furthermore, X^{C2} and X^{C4} are separated by L^{C2}, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, X^{C3} and X^{C4} are separated by L^{C3}, preferably by 1 to 10 atoms, more preferably by 1 to 6 atoms, still more preferably by 1 to 4 atoms, even still more preferably by 1 to 3 atoms, and particularly preferably by 1 or 2 atoms.

Furthermore, the description that X^{A1} and X^{A2} are separated by L^{A1} by 1 to 10 atoms means that the number of atoms constituting a molecular chain having the shortest distance, linking X^{A1} and X^{A2}, is 1 to 10. For example, in a case of Formula (A1), X^{A1} and X^{A2} are separated by 2 atoms, and in cases of Formulae (A2) and (A3), X^{A1} and X^{A2} are separated by 3 atoms. The numbers added to the following structural formulae represent the arrangement order of atoms constituting a molecular chain having the shortest distance, linking X^{A1} and X^{A2}.

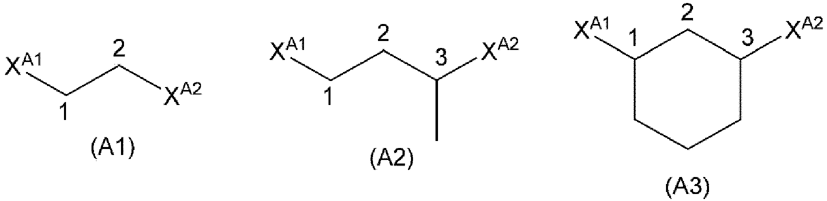

To explain with a specific compound, 3-mercaptopropionic acid is a compound (a compound having the following structure) having a structure in which a moiety corresponding to X^{A1} is a carboxy group, a moiety corresponding to X^{A2} is a thiol group, and a moiety corresponding to L^{A1} is an ethylene group. In 3-mercaptopropionic acid, X^{A1} (carboxy group) and X^{A2} (thiol group) are separated by L^{A1} (ethylene group) by 2 atoms.

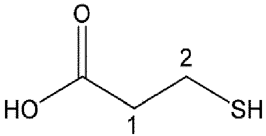

The same applies to the meanings that X^{B1} and X^{B3} are separated by L^{B1} by 1 to 10 atoms, X^{B2} and X^{B3} are separated by L^{B2} by 1 to 10 atoms, X^{C1} and X^{C4} are separated by L^{C1} by 1 to 10 atoms, X^{C2} and X^{C4} are separated by L^{C2} by 1 to 10 atoms, and X^{C3} and X^{C4} are separated by L^{C3} by 1 to 10 atoms.

Specific examples of the multidentate ligand include 3-mercaptopropionic acid, thioglycolic acid, 2-aminoethanol, 2-aminoethanethiol, 2-mercaptoethanol, glycolic acid, ethylene glycol, ethylenediamine, aminosulfonic acid, glycine, aminomethylphosphoric acid, guanidine, diethylenetriamine, tris(2-aminoethyl)amine, 4-mercaptobutanoic acid, 3-aminopropanol, 3-mercaptopropanol, N-(3-aminopropyl)-1,3-propanediamine, 3-(bis(3-aminopropyl)amino)propan-1-ol, 1-thioglycerol, dimercaprol, 1-mercapto-2-butanol, 1-mercapto-2-pentanol, 3-mercapto-1-propanol, 2,3-dimercapto-1-propanol, diethanolamine, 2-(2-aminoethyl)aminoethanol, dimethylenetriamine, 1,1-oxybismethylamine, 1,1-thiobismethylamine, 2-[(2-aminoethyl)amino]ethanethiol, bis(2-mercaptoethyl)amine, 2-aminoethane-1-thiol, 1-amino-2-butanol, 1-amino-2-pentanol, L-cysteine, D-cysteine, 3-amino-1-propanol, L-homoserine, D-homoserine, aminohydroxyacetic acid, L-lactic acid, D-lactic acid, L-malic acid, D-malic acid, glyceric acid, 2-hydroxybutyric acid, L-tartaric acid, D-tartaric acid, tartronic acid, 1,2-benzenedithiol, 1,3-benzenedithiol, 1,4-benzenedithiol, 2-mercaptobenzoic acid, 3-mercaptobenzoic acid, 4-mercaptobenzoic acid, and derivatives thereof.

In the quantum dot layer 13, a maximal absorption wavelength is present in a wavelength range of 900 to 1,700 nm. The maximal absorption wavelength of the quantum dot layer is preferably present in a wavelength range of 1,300 to 1,500 nm.

It is preferable that the quantum dot layer 13 has a higher absorbance at a wavelength of 550 nm than that at a wavelength of 1,450 nm. According to this aspect, the effects of the present disclosure are more remarkable. A ratio of the absorbance at a wavelength of 550 nm to the absorbance at a wavelength of 1,450 nm (absorbance at wavelength of 550 nm/absorbance at wavelength of 1,450 nm) is preferably 1.1 or more, more preferably 2 or more, and still more preferably 5 or more. An upper limit thereof is not particularly limited, but can be 1,000 or less.

A thickness of the quantum dot layer 13 is preferably 10 to 2,000 nm. A lower limit thereof is preferably 50 nm or more, and more preferably 200 nm or more. An upper limit of the thickness is preferably 1,000 nm or less, and more preferably 700 nm or less. The thickness of the quantum dot layer 13 is particularly preferably 200 to 700 nm.

The quantum dot layer 13 can be formed through a step of applying a dispersion liquid (hereinafter also referred to as a quantum dot dispersion liquid) including quantum dots.

Examples of the quantum dot dispersion liquid include a dispersion liquid including quantum dots and a solvent.

The details of the quantum dot are as described above, and the same applies to the preferred aspect thereof. A content of the quantum dots in the dispersion liquid is preferably 1 to 500 mg/mL, more preferably 10 to 200 mg/mL, and still more preferably 20 to 100 mg/mL.

The solvent is not particularly limited, but is preferably a solvent in which the quantum dots are hardly dissolved. The solvent is preferably an organic solvent. Specific examples thereof include alkanes (n-hexane, n-octane, and the like), alkenes (octadecene and the like), benzene, and toluene. The solvent included in the quantum dot dispersion liquid may be of only one kind or may be a mixed solvent in which two or more kinds of the solvents are mixed.

A content of the solvent in the quantum dot dispersion liquid is preferably 50% to 99% by mass, more preferably 70% to 99% by mass, and still more preferably 90% to 98% by mass.

The quantum dot dispersion liquid may further include a ligand coordinated to the quantum dot. Examples of the ligand included in the quantum dot dispersion liquid include the above-described organic ligand and the above-described inorganic ligand, and the quantum dot dispersion liquid preferably includes the above-described inorganic ligand.

The quantum dot dispersion liquid may include a ligand that acts as a ligand that is coordinated to the quantum dot and concurrently has a molecular structure that easily causes steric hindrance, thereby also serving as a dispersant that disperses the quantum dots in the solvent. Examples of such a ligand include a ligand having a main chain having at least 6 or more carbon atoms, and a ligand having a main chain having 10 or more carbon atoms is preferable. The ligand may be a saturated compound or may be an unsaturated compound. Specific examples thereof include decanoic acid, lauric acid, myristic acid, palmitic acid, stearic acid, behenic acid, oleic acid, erucic acid, oleylamine, stearylamine, 1-aminodecane, dodecylamine, aniline, dodecanethiol, 1,2-hexadecanethiol, tributylphosphine, trihexylphosphine, trioctylphosphine, tributylphosphine oxide, trioctylphosphine oxide, and cetrimonium bromide.

A content of the ligand in the quantum dot dispersion liquid is preferably 0.2 to 3.0 mol/L, and more preferably 0.2 to 1.0 mol/L.

A method for applying the dispersion liquid onto a support is not particularly limited. Examples thereof include coating methods such as a spin coating method, a dipping method, an ink jet method, a dispenser method, a screen printing method, a relief printing method, an intaglio printing method, and a spray coating method.

After forming a film of an aggregate of quantum dots by applying the quantum dot dispersion liquid, a step of applying the ligand solution to the above-described film may be performed. In a case where this step is performed, the ligand coordinated to the quantum dot can be exchanged with a ligand included in the ligand solution, or a ligand included in the ligand solution can be coordinated to the quantum dot to suppress the generation of surface defects of the quantum dot. The step of applying the quantum dot dispersion liquid and the step of applying the ligand solution may be alternately repeated a plurality of times.

Examples of the ligand included in the ligand solution include the ligands described as the ligand included in the quantum dot layer. The ligand included in the ligand solution may be the same as or different from the ligand included in the quantum dot dispersion liquid. The ligand solution may include only one kind or two or more kinds of the ligands. In addition, in the step of applying the ligand solution, two or more kinds of the ligand solutions may be used.

The solvent included in the ligand solution is preferably selected appropriately according to the kind of the ligand included in each ligand solution, and is preferably a solvent that easily dissolves each ligand. In addition, the solvent included in the ligand solution is preferably an organic solvent having a high dielectric constant. Specific examples thereof include ethanol, acetone, methanol, acetonitrile, dimethylformamide, dimethyl sulfoxide, butanol, and propanol. In addition, the solvent included in the ligand solution is preferably a solvent that is not likely to remain in the quantum dot layer thus formed. From the viewpoints of easy drying and easy removal by washing, a low boiling point alcohol, a ketone, or a nitrile is preferable, and methanol, ethanol, acetone, or acetonitrile is more preferable. The solvent included in the ligand solution is preferably one that does not mix with the solvent included in the quantum dot dispersion liquid. With regard to a preferred combination of the solvents, in a case where the solvent included in the quantum dot dispersion liquid is an alkane such as hexane and octane, or toluene, it is preferable to use a polar solvent such as methanol and acetone as the solvent included in the ligand solution.

A step of bringing a rinsing liquid into contact with the film (rinsing step) after performing the step of applying the ligand may be performed. By performing the rinsing step, it is possible to remove an excess ligand included in the quantum dot layer or a ligand dissociated from the quantum dot. In addition, the rinsing step may be performed a plurality of times by using two or more kinds of rinsing liquids that differ in polarity (relative permittivity). For example, it is preferable that first, a rinsing liquid having a high relative permittivity (also referred to as a first rinsing liquid) is used to perform rinsing, and then a rinsing liquid having a relative permittivity lower than that of the first rinsing liquid (also referred to as a second rinsing liquid) is used to perform rinsing. The relative permittivity of the first rinsing liquid is preferably 15 to 50, more preferably 20 to 45, and still more preferably 25 to 40. The relative permittivity of the second rinsing liquid is preferably 1 to 15, more preferably 1 to 10, and still more preferably 1 to 5.

A drying step may be performed in the formation of the quantum dot layer. The drying time is preferably 1 to 100 hours, more preferably 1 to 50 hours, and still more preferably 5 to 30 hours. The drying temperature is preferably 10°C to 100°C, more preferably 20°C to 90°C, and still more preferably 20°C to 60°C. The drying step may be performed in an atmosphere including oxygen or in a nitrogen atmosphere.

### (Electron Transport Layer)

The photoelectric conversion element 10 may be provided with an electron transport layer between the first electrode 11 or the second electrode 12 and the quantum dot layer 13. The electron transport layer is a layer having a function of transporting electrons generated in the quantum dot layer 13 to the electrode. The electron transport layer is also called a hole block layer. The electron transport layer is formed of an electron transport material capable of exhibiting this function.

Examples of the electron transport material include fullerene compounds such as [6,6]-phenyl-C61-butyric acid methyl ester (PC₆₁BM), perylene compounds such as perylenetetracarboxylic diimide, tetracyanoquinodimethane, titanium oxide, tin oxide, zinc oxide, indium oxide, indium tungsten oxide, indium zinc oxide, indium tin oxide, and fluorine-doped tin oxide. The electron transport material may be a particle.

It is also preferable that the electron transport layer is composed of a layer including zinc oxide doped with a metal atom other than Zn. Hereinafter, the zinc oxide doped with a metal atom other than Zn is also referred to as the doped zinc oxide.

The metal atom other than Zn in the doped zinc oxide is preferably a monovalent to trivalent metal atom, more preferably a metal atom including at least one selected from Li, Mg, Al, or Ga, still more preferably Li, Mg, Al, or Ga, and particularly preferably Li or Mg.

In the doped zinc oxide, a proportion of the metal atoms other than Zn to a total of Zn and the metal atoms other than Zn is preferably 1% by atom or more, more preferably 2% by atom or more, and still more preferably 4% by atom or more. From the viewpoint of suppressing an increase in crystal defects, an upper limit of the proportion is preferably 20% by atom or less, more preferably 15% by atom or less, and still more preferably 12% by atom or less. Furthermore, a proportion of the metal atoms other than Zn in the doped zinc oxide can be measured according to a high-frequency inductively coupled plasma (ICP) method.

From the viewpoint of reducing the organic residual component and increasing the area for contact with the quantum dot layer, the doped zinc oxide is preferably a particle (doped zinc oxide particle). In addition, an average particle diameter of the doped zinc oxide particles is preferably 2 to 30 nm. A lower limit value of the average particle diameter of the doped zinc oxide particles is preferably 3 nm or more, and more preferably 5 nm or more. In addition, an upper limit value of the average particle diameter of the doped zinc oxide particles is preferably 20 nm or less, and more preferably 15 nm or less. Furthermore, in the present specification, the value of the average particle diameter of the doped zinc oxide particles is an average value of the particle diameters of ten quantum dots which are randomly selected. A transmission electron microscope may be used to measure the particle diameters of the doped zinc oxide particles.

The electron transport layer may be a single-layer film or a laminated film having two or more layers. A thickness of the electron transport layer is preferably 10 to 1,000 nm. An upper limit thereof is preferably 800 nm or less. A lower limit of the thickness is preferably 20 nm or more, and more preferably 50 nm or more.

### (Hole Transport Layer)

The photoelectric conversion element 10 may be provided with a hole transport layer between the first electrode 11 or the second electrode 12 and the quantum dot layer 13. The hole transport layer is a layer having a function of transporting holes generated in the quantum dot layer 13 to the electrode. The hole transport layer is also called an electron block layer.

The hole transport layer is formed of a hole transport material capable of exhibiting this function. Examples of the hole transport material include PEDOT:PSS (poly(3,4-ethylenedioxythiophene):poly(4-styrenesulfonic acid)), PTB7 (poly{4,8-bis[(2-ethylhexyl)oxy]benzo[1,2-b:4,5-b']dithiophen-2,6-diyl-lt-alt-3-fluoro-2-[(2-ethylhexyl)carbonyl]thieno[3,4-b]thiophen-4,6-diyl}), PTB7-Th (poly([2,6'-4,8-di(5-ethylhexylthienyl)benzo[1,2-b:3,3-b']dithiophen]{3-fluoro-2-[(2-ethylhexyl)carbonyl]thieno[3,4-b]thiophendiyl})), PC71BM ([6,6]-phenyl-C71-methyl butyrate), and MoO₃. Furthermore, the organic hole transport material disclosed in paragraph Nos. 0209 to 0212 of JP2001-291534A can also be used. In addition, a quantum dot can also be used in the hole transport material. Examples of the quantum dot material constituting the quantum dot include a nanoparticle (a particle having a size of 0.5 nm or more and less than 100 nm) of a general semiconductor crystal [a) a Group IV semiconductor, b) a compound semiconductor of a Group IV to IV element, a Group III to V element, or a Group II to VI element, or c) a compound semiconductor consisting of a combination of three or more of a Group II element, a Group III element, a Group IV element, a Group V element, and a Group VI element]. Specific examples thereof include semiconductor materials having a relatively narrow band gap, such as PbS, PbSe, PbSeS, InN, Ge, InAs, InGaAs, CuInS, CuInSe, CuInGaSe, InSb, HgTe, HgCdTe, Ag₂S, Ag₂Se, Ag₂Te, SnS, SnSe, SnTe, Si, and InP. A ligand may be coordinated to a surface of the quantum dot.

A thickness of the hole transport layer is preferably 5 to 100 nm. A lower limit thereof is preferably 10 nm or more. An upper limit of the thickness is preferably 50 nm or less, and more preferably 30 nm or less.

### <<Interlayer 20>>

The photodetector element of the embodiment of the present invention has an interlayer 20 between the photoelectric conversion element 10 and the optical filter 30.

In the photodetector element of the first aspect of the present invention, the interlayer 20 is configured to include at least one kind of atom selected from the group consisting of Si, Al, Zr, Sn, Zn, Ce, and Hf, or to include a paraxylene polymer. Examples of the paraxylene polymer include an unsubstituted paraxylene polymer, a paraxylene polymer in which a hydrogen atom of a benzene ring is substituted with a chlorine atom, and a paraxylene polymer in which the α-hydrogen atom is substituted with a fluorine atom.

In the photodetector element of the second aspect of the present invention, the interlayer 20 has a water vapor permeability as determined by a method in accordance with JIS K 7129 of 1 × 10⁻⁴ g/m²/day or less.

It is preferable that the interlayer 20 is a film including at least one selected from the group consisting of silicon oxide, silicon oxynitride, silicon nitride, zirconium oxide, zinc oxide, cerium oxide, aluminum oxide, hafnium oxide, and a paraxylene polymer.

The interlayer 20 can be formed by a method such as a physical vapor deposition method (PVD) such as a vacuum deposition method and sputtering, a chemical vapor deposition method (CVD), and an atomic layer deposition method (ALD), and due to excellent adhesiveness and suppression of a dark current, the interlayer 20 preferably includes a film formed by the atomic layer deposition method, and more preferably includes a film formed by the atomic layer deposition method, using at least one selected from the group consisting of silicon oxide, silicon oxynitride, silicon nitride, zirconium oxide, zinc oxide, cerium oxide, aluminum oxide, and hafnium oxide. Here, the atomic layer deposition method is a film forming method using a continuous chemical reaction in a gas phase.

The interlayer 20 may be a monolayer film or a laminated film in which two or more kinds of films are laminated.

The interlayer 20 preferably has a high transmittance of light in a wavelength range of 400 to 1,500 nm, and the transmittance of light in the above-described range is more preferably 70% or more, still more preferably 80% or more, even more preferably 90% or more, and particularly preferably 95% or more.

A thickness of the interlayer 20 is preferably 1 to 100,000 nm. A lower limit thereof is preferably 10 nm or more, and more preferably 20 nm or more. An upper limit of the thickness is preferably 10,000 nm or less, and more preferably 1,000 nm or less.

A ratio of the thickness of the interlayer 20 to the thickness of the quantum dot layer 13 (thickness of interlayer 20/thickness of quantum dot layer 13) is preferably 0.01 to 1. In a case where the ratio is within the range, the suppression of the dark current is excellent. Furthermore, the variation in in-plane performance can be suppressed. A lower limit of the ratio is preferably 0.02 or more, and more preferably 0.03 or more. An upper limit of the ratio is preferably 0.8 or less, and more preferably 0.5 or less.

### <<Optical Filter 30>>

The photodetector element of the embodiment of the present invention has the optical filter 30. The optical filter 30 is provided on the interlayer 20. In Fig. 1, the optical filter 30 is directly provided on a surface of the interlayer 20, but a base layer may be formed on a surface of the interlayer 20 and the optical filter 30 may be provided on a surface of the base layer.

The optical filter 30 has spectral characteristics in which a maximum value of a transmittance of light in a wavelength range of 400 to 700 nm is 20% or less, and a maximum value of a transmittance of light in a range of the maximal absorption wavelength of the quantum dot layer ± 100 nm is 60% or more.

The maximum value of the transmittance of light in a wavelength range of 400 to 700 nm of the optical filter 30 is preferably 18% or less, and more preferably 15% or less.

The maximum value of the transmittance of light in a range of the maximal absorption wavelength of the quantum dot layer 13 of the optical filter 30 ± 100 nm (preferably in a range of the maximal absorption wavelength ± 90 nm, and more preferably in a range of the maximal absorption wavelength ± 80 nm) is preferably 70% or more, and more preferably 80% or more. In addition, the minimum value of the transmittance of light in a range of the maximal absorption wavelength of the quantum dot layer 13 of the optical filter 30 ± 50 nm is preferably 60% or more, more preferably 70% or more, and still more preferably 80% or more.

In the photodetector element of the embodiment of the present invention, it is preferable that the maximal absorption wavelength of the quantum dot layer 13 is present in a wavelength range of 1,300 to 1,500 nm, and in the optical filter 30, a maximum value of a transmittance of light in a wavelength range of 400 to 700 nm (preferably a wavelength range of 400 to 1,200 nm) is 20% or less, and a maximum value of a transmittance of light in a wavelength range of 1,300 to 1,500 nm is 60% or more. In this aspect, the maximum value of the transmittance in a wavelength range of 400 to 700 nm (preferably a wavelength range of 400 to 1,200 nm) of the optical filter 30 is preferably 18% or less, and more preferably 15% or less. Furthermore, the maximum value of the transmittance in a wavelength range of 1,300 to 1,500 nm of the optical filter 30 is preferably 70% or more, and more preferably 80% or more. In addition, the minimum value of the transmittance to light in a wavelength range of 1,300 to 1,500 nm of the optical filter 30 is preferably 60% or more, more preferably 70% or more, and still more preferably 80% or more.

Such a photodetector element can accurately detect light in a wavelength range of 1,300 to 1,500 nm. Therefore, such a photodetector element can be preferably used in uses such as an infrared sensor, automatic driving, and a surveillance camera.

A thickness of the optical filter 30 is preferably 10 to 100,000 nm. A lower limit thereof is preferably 50 nm or more, and more preferably 100 nm or more. An upper limit of the thickness is preferably 50,000 nm or less, and more preferably 10,000 nm or less.

In addition, a ratio of the thickness of the optical filter 30 to the thickness of the quantum dot layer 13 is preferably 0.1 to 100. For a reason that the fluctuation in dark current can be further suppressed and the in-plane variation in performance can be suppressed, the upper limit is preferably 50 or less, and more preferably 10 or less. For a reason that the fluctuation in dark current can be further suppressed and the in-plane variation in performance can be suppressed, the lower limit is preferably 0.5 or more, and more preferably 1 or more.

It is preferable that the optical filter 30 is a resin film containing a plurality of coloring materials. The optical filter 30 may be a resin film of a single layer containing a plurality of coloring materials. Examples of the coloring material included in the resin film include a red coloring material, a green coloring material, a blue coloring material, a yellow coloring material, a violet coloring material, a chromatic coloring material such as an orange coloring material, and an infrared absorbing coloring material.

The coloring material may be a pigment or a dye. For a reason that the long-term reliability is excellent, it is preferable that the coloring material includes the pigment. The pigment may be either an inorganic pigment or an organic pigment, but the organic pigment is preferable. An average primary particle diameter of the pigment is preferably 1 to 150 nm. A lower limit thereof is preferably 2 nm or more, and more preferably 5 nm or more. An upper limit of the average primary particle diameter of the pigment is preferably 150 nm or less, more preferably 100 nm or less, and still more preferably 50 nm or less. In a case where the average primary particle diameter of the pigment is in the range, the transmittance of the target wavelength is good. Furthermore, in the present specification, the primary particle diameter of the pigment can be determined from an image obtained by observing primary particles of the pigment using a transmission electron microscope. Specifically, a projected area of the primary particles of the pigment is determined, and the corresponding equivalent circle diameter is calculated as the primary particle diameter of the pigment. Furthermore, the average primary particle diameter in the present invention is an arithmetic average of the primary particle diameters with respect to 400 primary particles of the pigment. In addition, the primary particles of the pigment refer to particles which are independent without aggregation.

For the pigment, a crystal grain size obtained from a half-width of a peak derived from any crystal plane in the X-ray diffraction spectrum in a case where a CuKα ray is used as the X-ray source is preferably 0.1 to 100 nm, and more preferably 0.5 to 50 nm.

A specific surface area of the pigment is preferably 1 to 300 m²/g. A lower limit thereof is preferably 10 m²/g or more, and more preferably 30 m²/g or more. An upper limit of the specific surface area is preferably 250 m²/g or less, and more preferably 200 m²/g or less. The value of the specific surface area can be measured according to determination of the specific surface area of solids by gas adsorption (DIN 66131) in accordance with the Brunauer, Emmett, and Teller (BET) method.

Examples of the chromatic coloring material include a coloring material having a maximal absorption wavelength in a wavelength range of 400 to 700 nm. Examples thereof include a yellow coloring material, an orange coloring material, a red coloring material, a green coloring material, a violet coloring material, and a blue coloring material.

Examples of the red coloring material include a diketopyrrolopyrrole compound, an anthraquinone compound, an azo compound, a naphthol compound, an azomethine compound, a xanthene compound, a quinacridone compound, a perylene compound, and a thioindigo compound. The diketopyrrolopyrrole compound, the anthraquinone compound, or the azo compound is preferable, and the diketopyrrolopyrrole compound is more preferable. In addition, the red coloring material is preferably a pigment.

Specific examples of the red coloring material include red pigments such as Color Index (C. I.) Pigment Red 1, 2, 3, 4, 5, 6, 7, 9, 10, 14, 17, 22, 23, 31, 38, 41, 48:1, 48:2, 48:3, 48:4, 49, 49:1, 49:2, 52:1, 52:2, 53:1, 57:1, 60:1, 63:1, 66, 67, 81:1, 81:2, 81:3, 83, 88, 90, 105, 112, 119, 122, 123, 144, 146, 149, 150, 155, 166, 168, 169, 170, 171, 172, 175, 176, 177, 178, 179, 184, 185, 187, 188, 190, 200, 202, 206, 207, 208, 209, 210, 216, 220, 224, 226, 242, 246, 254, 255, 264, 269, 270, 272, 279, 291, 294, 295, 296, and 297. Moreover, as the red pigment, the diketopyrrolopyrrole compounds with a structure having at least one bromine atom substituted, among the structures described in JP2017-201384A, the diketopyrrolopyrrole compounds described in paragraph Nos. 0016 to 0022 of JP6248838B, the diketopyrrolopyrrole compounds described in WO2012/102399A, the diketopyrrolopyrrole compounds described in WO2012/117965A, the brominated diketopyrrolopyrrole compounds described in JP2020-085947A, the naphtholazo compounds described in JP2012-229344A, the red pigment described in JP6516119B, the red pigment described in JP6525101B, the brominated diketopyrrolopyrrole compounds described in paragraph No. 0229 of JP2020-090632A, the anthraquinone compounds described in KR10-2019-0140741A, the anthraquinone compounds described in KR10-2019-0140744A, the perylene compounds described in JP2020-079396A, the diketopyrrolopyrrole compounds described in paragraph Nos. 0025 to 0041 of JP2020-066702A, or the like can also be used. In addition, as the red coloring material, a compound with a structure in which an aromatic ring group in which a group bonded with an oxygen atom, a sulfur atom, or a nitrogen atom is introduced to an aromatic ring is bonded to a diketopyrrolopyrrole skeleton can also be used.

Examples of the green coloring material include a phthalocyanine compound and a squarylium compound, and the phthalocyanine compound is preferable. In addition, the green coloring material is preferably a pigment.

Specific examples of the green coloring material include green pigments such as C. I. Pigment Green 7, 10, 36, 37, 58, 59, 62, 63, 64, 65, and 66. In addition, as the green coloring material, a halogenated zinc phthalocyanine pigment having an average number of halogen atoms in one molecule of 10 to 14, an average number of bromine atoms in one molecule of 8 to 12, and an average number of chlorine atoms in one molecule of 2 to 5 can also be used. Specific examples thereof include the compounds described in WO2015/118720A. In addition, as the green coloring material, the compounds described in CN106909027A, the phthalocyanine compounds described in WO2012/102395A, which have a phosphoric acid ester as a ligand, the phthalocyanine compounds described in JP2019-008014A, the phthalocyanine compounds described in JP2018-180023A, the compounds described in JP2019-038958A, the aluminum phthalocyanine compounds described in JP2020-070426A, the core-shell type coloring agents described in JP2020-076995A, the diarylmethane compounds described in JP2020-504758A, or the like can be used.

Specific examples of the orange coloring material include orange pigments such as C. I. Pigment Orange 2, 5, 13, 16, 17:1, 31, 34, 36, 38, 43, 46, 48, 49, 51, 52, 55, 59, 60, 61, 62, 64, 71, and 73.

Examples of the yellow coloring material include an azo compound, an azomethine compound, an isoindoline compound, a pteridine compound, a quinophthalone compound, and a perylene compound. Specific examples of the yellow coloring material include yellow pigments such as C. I. Pigment Yellow 1, 2, 3, 4, 5, 6, 10, 11, 12, 13, 14, 15, 16, 17, 18, 20, 24, 31, 32, 34, 35, 35:1, 36, 36:1, 37, 37:1, 40, 42, 43, 53, 55, 60, 61, 62, 63, 65, 73, 74, 77, 81, 83, 86, 93, 94, 95, 97, 98, 100, 101, 104, 106, 108, 109, 110, 113, 114, 115, 116, 117, 118, 119, 120, 123, 125, 126, 127, 128, 129, 137, 138, 139, 147, 148, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 199, 213, 214, 215, 228, 231, 232, 233, 234, 235, and 236.

Moreover, as the yellow coloring material, an azobarbiturate nickel complex having the following structure can also be used.

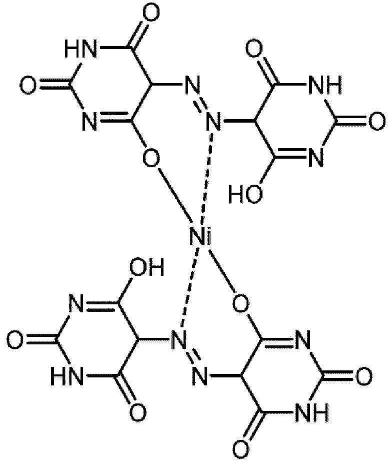

In addition, as the yellow coloring material, the compounds described in JP2017-201003A, the compounds described in JP2017-197719A, the compounds described in paragraph Nos. 0011 to 0062 and 0137 to 0276 of JP2017-171912A, the compounds described in paragraph Nos. 0010 to 0062 and 0138 to 0295 of JP2017-171913A, the compounds described in paragraph Nos. 0011 to 0062 and 0139 to 0190 of JP2017-171914A, the compounds described in paragraph Nos. 0010 to 0065 and 0142 to 0222 of JP2017-171915A, the quinophthalone compounds described in paragraph Nos. 0011 to 0034 of JP2013-054339A, the quinophthalone compounds described in paragraph Nos. 0013 to 0058 of JP2014-026228A, the isoindoline compounds described in JP2018-062644A, the quinophthalone compounds described in JP2018-203798A, the quinophthalone compounds described in JP2018-062578A, the quinophthalone compounds described in JP6432076B, quinophthalone compounds described in JP2018-155881A, the quinophthalone compounds described in JP2018-111757A, the quinophthalone compounds described in JP2018-040835A, the quinophthalone compounds described in JP2017-197640A, the quinophthalone compounds described in JP2016-145282A, the quinophthalone compounds described in JP2014-085565A, the quinophthalone compounds described in JP2014-021139A, the quinophthalone compounds described in JP2013-209614A, the quinophthalone compounds described in JP2013-209435A, the quinophthalone compounds described in JP2013-181015A, the quinophthalone compounds described in JP2013-061622A, the quinophthalone compounds described in JP2013-032486A, the quinophthalone compounds described in JP2012-226110A, the quinophthalone compounds described in JP2008-074987A, the quinophthalone compounds described in JP2008-081565A, the quinophthalone compounds described in JP2008-074986A, the quinophthalone compounds described in JP2008-074985A, the quinophthalone compounds described in JP2008-050420A, the quinophthalone compounds described in JP2008-031281A, the quinophthalone compounds described in JP1973-032765B (JP-S48-032765B), the quinophthalone compounds described in JP2019-008014A, the quinophthalone compounds described in JP6607427B, the methine dyes described in JP2019-073695A, the methine dyes described in JP2019-073696A, the methine dyes described in JP2019-073697A, the methine dyes described in JP2019-073698A, the compounds described in KR10-2014-0034963A, the compounds described in JP2017-095706A, the compounds described in TW2019-20495A, the compounds described in JP6607427B, the compounds described in JP2020-033525A, the compounds described in JP2020-033524A, the compounds described in JP2020-033523A, the compounds described in JP2020-033522A, the compounds described in JP2020-033521A, the compounds described in WO2020/045200A, the compounds described in WO2020/045199A, the compounds described in WO2020/045197A, the azo compounds described in JP2020-093994A, the perylene compounds described in JP2020-083982A, the perylene compounds described in WO2020/105346A, or the quinophthalone compounds described in JP2020-517791A can also be used. In addition, from the viewpoint of improving a color value, multimerized compounds of these compounds are also preferably used.

Specific examples of the violet coloring material include violet pigments such as C. I. Pigment Violet 1, 19, 23, 27, 32, 37, 42, 60, and 61.

Specific examples of the blue coloring material include blue pigments such as C. I. Pigment Blue 1, 2, 15, 15:1, 15:2, 15:3, 15:4, 15:6, 16, 22, 29, 60, 64, 66, 79, 80, 87, and 88. As the blue coloring material, an aluminum phthalocyanine compound having a phosphorus atom can also be used. Specific examples thereof include the compounds described in paragraph Nos. 0022 to 0030 of JP2012-247591A and paragraph No. 0047 of JP2011-157478A.

As the chromatic coloring material, the triarylmethane dye polymers described in KR10-2020-0028160A, the xanthene compounds described in JP2020-117638A, the phthalocyanine compounds described in WO2020/174991A, the isoindoline compounds or salts thereof described in JP2020-160279A, the compound represented by Formula 1 described in KR10-2020-0069442A, the compound represented by Formula 1 described in KR10-2020-0069730A, the compound represented by Formula 1 described in KR10-2020-0069070A, the compound represented by Formula 1 described in KR10-2020-0069067A, the compound represented by Formula 1 described in KR10-2020-0069062A, the zinc phthalocyanine pigment described in JP6809649B, the isoindoline compounds described in JP2020-180176A, the phenothiazine-based compounds described in JP2021-187913A, the zinc phthalocyanine halides described in WO2022/004261A, or the zinc phthalocyanine halides described in WO2021/250883A can be used. The pigment or the dye may be rotaxane, the coloring agent skeleton may be used in a cyclic structure of the rotaxane, may be used in a rod-like structure, or may be used in both structures.

The infrared absorbing coloring material is preferably a coloring material having a maximal absorption wavelength in a wavelength range of more than 700 nm and 1,400 nm or less.

In the infrared absorbing coloring material, A₅₅₀/Aₘₐₓ, which is a ratio of an absorbance A₅₅₀ at a wavelength of 550 nm to an absorbance Aₘₐₓ at the maximal absorption wavelength, is preferably 0.1 or less, more preferably 0.05 or less, still more preferably 0.03 or less, and particularly preferably 0.02 or less. A lower limit thereof is not particularly limited, but can be, for example, 0.0001 or more, and can also be 0.0005 or more.

The infrared absorbing coloring material is not particularly limited, but examples thereof include a pyrrolopyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, and inorganic particles. Examples of the pyrrolopyrrole compound include the compounds described in paragraph Nos. 0016 to 0058 of JP2009-263614A, the compounds described in paragraph Nos. 0037 to 0052 of JP2011-068731A, and the compounds described in paragraph Nos. 0010 to 0033 of WO2015/166873A. Examples of the squarylium compound include the compounds described in paragraph Nos. 0044 to 0049 of JP2011-208101A, the compounds described in paragraph Nos. 0060 and 0061 of JP6065169B, the compounds described in paragraph No. 0040 of WO2016/181987A, the compounds described in JP2015-176046A, the compounds described in paragraph No. 0072 of WO2016/190162A, the compounds described in paragraph Nos. 0196 to 0228 of JP2016-074649A, the compounds described in paragraph No. 0124 of JP2017-067963A, the compounds described in WO2017/135359A, the compounds described in JP2017-114956A, the compounds described in JP6197940B, and the compounds described in WO2016/120166A. Examples of the cyanine compound include the compounds described in paragraph Nos. 0044 and 0045 of JP2009-108267A, the compounds described in paragraph Nos. 0026 to 0030 of JP2002-194040A, the compounds described in JP2015-172004A, the compounds described in JP2015-172102A, the compounds described in JP2008-088426A, the compounds described in paragraph No. 0090 of WO2016/190162A, and the compounds described in JP2017-031394A. Examples of the croconium compound include the compounds described in JP2017-082029A. Examples of the iminium compound include the compounds described in JP2008-528706A, the compounds described in JP2012-012399A, the compounds described in JP2007-092060A, and the compounds described in paragraph Nos. 0048 to 0063 of WO2018/043564A. Examples of the phthalocyanine compound include the compounds described in paragraph No. 0093 of JP2012-077153A, the oxytitanium phthalocyanine described in JP2006-343631A, the compounds described in paragraph Nos. 0013 to 0029 of JP2013-195480A, the vanadium phthalocyanine compounds described in JP6081771B, and the compounds described in WO2020/071470A. Examples of the naphthalocyanine compound include the compounds described in paragraph No. 0093 of JP2012-077153A. Examples of the dithiolene metal complex include the compounds described in JP5733804B. Examples of the inorganic particles include particles of indium tin oxide, antimony tin oxide, zinc oxide, Al-doped zinc oxide, fluorine-doped tin dioxide, niobium-doped titanium dioxide, tungsten oxide, or a metal boride. With regard to the details of the tungsten oxide, reference can be made to the description in paragraph No. 0080 of JP2016-006476A, the contents of which are incorporated herein by reference. Examples of the metal boride include lanthanum boride. Examples of a commercially available product of the lanthanum boride include LaB6-F (manufactured by Japan New Metals Co., Ltd.). The compounds described in WO2017/119394A can also be used as the metal boride.

As the infrared absorbing coloring material, the squarylium compounds described in JP2017-197437A, the squarylium compounds described in JP2017-025311A, the squarylium compounds described in WO2016/154782A, the squarylium compounds described in JP5884953B, the squarylium compounds described in JP6036689B, the squarylium compounds described in JP5810604B, the squarylium compounds described in paragraph Nos. 0090 to 0107 of WO2017/213047A, the pyrrole ring-containing compounds described in paragraph Nos. 0019 to 0075 of JP2018-054760A, the pyrrole ring-containing compounds described in paragraph Nos. 0078 to 0082 of JP2018-040955A, the pyrrole ring-containing compounds described in paragraph Nos. 0043 to 0069 of JP2018-002773A, the squarylium compounds having an aromatic ring at the α-amide position described in paragraph Nos. 0024 to 0086 of JP2018-041047A, the amide-linked squarylium compounds described in JP2017-179131A, the compounds having a pyrrole bis-type squarylium skeleton or a croconium skeleton described in JP2017-141215A, the dihydrocarbazole bis-type squarylium compounds described in JP2017-082029, the asymmetric compounds described in paragraph Nos. 0027 to 0114 of JP2017-068120A, the pyrrole ring-containing compounds (carbazole type) described in JP2017-067963A, the phthalocyanine compounds described in JP6251530B, the squarylium compounds described in JP2020-075959A, the copper complex described in KR10-2019-0135217A, or the like can also be used.

The coloring material included in the optical filter 30 preferably includes two or more chromatic coloring materials, more preferably includes two or more chromatic coloring materials and an infrared absorbing coloring material, and still more preferably includes two or more chromatic coloring materials and two or more infrared absorbing coloring materials. In a case where two or more kinds of chromatic coloring materials are included, it is preferable that a black color is formed by a combination of two or more kinds of chromatic coloring materials. With regard to a combination of coloring materials which form black color with the combination of two or more kinds of chromatic coloring materials, reference can be made to JP2013-077009A, JP2014-130338A, WO2015/166779A, and the like.

Examples of the combination of the chromatic coloring material in a case of forming a black color by a combination of two or more kinds of chromatic coloring materials include the following aspects (C1) to (C7).
(C1) An aspect containing a red coloring material and a blue coloring material.
(C2) An aspect containing a red coloring material, a blue coloring material, and a yellow coloring material.
(C3) An aspect containing a red coloring material, a blue coloring material, a yellow coloring material, and a purple coloring material.
(C4) An aspect containing a red coloring material, a blue coloring material, a yellow coloring material, a purple coloring material, and a green coloring material.
(C5) An aspect containing a red coloring material, a blue coloring material, a yellow coloring material, and a green coloring material.
(C6) An aspect containing a red coloring material, a blue coloring material, and a green coloring material.
(C7) An aspect containing a yellow coloring material and a purple coloring material.

In the aspect (C1), a mass ratio of the red coloring material to a blue coloring material is red coloring material:blue coloring material of preferably 20 to 80:20 to 80, more preferably 20 to 60:40 to 80, and still more preferably 20 to 50:50 to 80.

In the aspect (C2), a mass ratio of the red coloring material to the blue coloring material to the yellow coloring material is red coloring material:blue coloring material:yellow coloring material of preferably 10 to 80:20 to 80:10 to 40, more preferably 10 to 60:30 to 80:10 to 30, and still more preferably 10 to 40:40 to 80:10 to 20.

In the aspect (C3), a mass ratio of the red coloring material to the blue coloring material to the yellow coloring material to the violet coloring material is red coloring material:blue coloring material:yellow coloring material:violet coloring material of preferably 10 to 80:20 to 80:5 to 40:5 to 40, more preferably 10 to 60:25 to 80:5 to 30:5 to 30, and still more preferably 10 to 40:25 to 50:10 to 30:10 to 30.

In the aspect (C4), a mass ratio of the red coloring material to the blue coloring material to the yellow coloring material to the violet coloring material to the green coloring material is red coloring material:blue coloring material:yellow coloring material:violet coloring material:green coloring material of preferably 10 to 80:20 to 80:5 to 40:5 to 40:5 to 40, more preferably 10 to 60:30 to 80:5 to 30:5 to 30:5 to 30, and still more preferably 10 to 40:40 to 80:5 to 20:5 to 20:5 to 20.

In the aspect (C5), a mass ratio of the red coloring material to the blue coloring material to the yellow coloring material to the green coloring material is red coloring material:blue coloring material:yellow coloring material:green coloring material of preferably 10 to 80:20 to 80:5 to 40:5 to 40, more preferably 10 to 60:30 to 80:5 to 30:5 to 30, and still more preferably 10 to 40:40 to 80:5 to 20:5 to 20.

In the aspect (C6), a mass ratio of the red coloring material to the blue coloring material to the green coloring material is red coloring material:blue coloring material:green coloring material of preferably 10 to 80:20 to 80: 10 to 40, more preferably 10 to 60:30 to 80: 10 to 30, and still more preferably 10 to 40:40 to 80:10 to 20.

In the aspect (C7), a mass ratio of the yellow coloring material to the violet coloring material is yellow coloring material:violet coloring material of preferably 10 to 50:40 to 80, more preferably 20 to 40:50 to 70, and still more preferably 30 to 40:60 to 70.

In a case where the coloring material included in the optical filter 30 includes two or more kinds of infrared absorbing coloring materials, it is preferable that the two or more kinds of infrared absorbing coloring materials include a first infrared absorbing coloring material in which a maximal absorption wavelength is present in a wavelength range of more than 1,000 nm and 1,200 nm or less, and a second infrared absorbing coloring material in which a maximal absorption wavelength is present in a wavelength range of more than 700 nm and 1,000 nm or less. For example, the coloring material included in the optical filter 30 includes two or more kinds of chromatic coloring materials and two or more kinds of infrared absorbing coloring materials, and black color is formed by a combination of the two or more kinds of chromatic coloring materials, and thus, in a case where the infrared absorbing coloring materials includes a first infrared absorbing coloring material in which a maximal absorption wavelength is present in a wavelength range of more than 1,000 nm and 1,200 nm or less and a second infrared absorbing coloring material in which a maximal absorption wavelength is present in a wavelength range of more than 700 nm and 1,000 nm or less, it is easy to adjust the spectral characteristics of the optical filter 30 such that the maximal value of a transmittance of light in a wavelength range of 400 to 1,200 nm is 20% or less and the maximal value of a transmittance of light in a wavelength range of 1,300 to 1,500 nm is 60% or more. The first infrared absorbing coloring material may be of one kind or of two or more kinds. The second infrared absorbing coloring material may be of one kind or of two or more kinds. A ratio of the first infrared absorbing coloring material to the second infrared absorbing coloring material is preferably 1 to 10,000 parts by mass of the second infrared absorbing coloring material with respect to 100 parts by mass of the first infrared absorbing coloring material. An upper limit thereof is preferably 1,000 parts by mass or less, and more preferably 500 parts by mass or less. A lower limit of the ratio is preferably 10 parts by mass or more, and more preferably 50 parts by mass or more.

The optical filter 30 can be formed through a step of applying a composition for forming an optical filter onto the interlayer 20.

As a method for applying the composition for forming an optical filter, a known method can be used. Examples thereof include a dropping method (drop casting); a slit coating method; a spray method; a roll coating method; a spin coating method (spin coating); a cast coating method; a slit and spin method; a pre-wet method (for example, a method described in JP2009-145395A), various printing methods such as an ink jet (for example, on-demand type, piezo type, thermal type), a discharge printing such as nozzle jet, a flexo printing, a screen printing, a gravure printing, a reverse offset printing, and a metal mask printing; a transfer method using molds and the like; and a nanoimprinting method. A method for applying the ink jet is not particularly limited, and examples thereof include the method described in "Extension of Use of Ink Jet -Infinite Possibilities in Patent-" (February, 2005, S. B. Research Co., Ltd.) (particularly pp. 115 to 133) and the methods described in JP2003-262716A, JP2003-185831A, JP2003-261827A, JP2012-126830A, and JP2006-169325A. In addition, with regard to the method for applying the coloring composition, reference can be made to the description in WO2017/030174A and WO2017/018419A, the contents of which are incorporated herein by reference.

A composition layer for forming an optical filter formed on the interlayer 20 may be dried (pre-baked). In a case of producing a film by a low-temperature process, pre-baking may not be performed. In a case of performing the pre-baking, the pre-baking temperature is preferably 150°C or lower, more preferably 120°C or lower, and still more preferably 110°C or lower. A lower limit thereof may be set to, for example, 50°C or higher, or to 80°C or higher. The pre-baking time is preferably 10 to 300 seconds, more preferably 40 to 250 seconds, and still more preferably 80 to 220 seconds. The pre-baking can be performed using a hot plate, an oven, or the like.

The optical filter 30 is preferably formed by applying a composition for forming an optical filter onto the interlayer 20 to form a composition layer for forming an optical filter and exposing the composition layer for forming an optical filter, and more preferably formed by exposing the composition layer for forming an optical filter two or more times.

In a case of forming the optical filter 30, it is also preferable to patternwise expose the composition layer for forming an optical filter and to remove the non-exposed portion of the composition layer for forming an optical filter by development, thereby forming a pattern.

For example, the composition layer for forming an optical filter can be patternwise exposed using a stepper exposure machine, a scanner exposure machine, or the like through a mask having a predetermined mask pattern. As a result, the exposed portion of the composition layer for forming an optical filter can be cured.

Examples of the radiation (light) that can be used at the time of exposure include g-rays and i-rays. In addition, light (preferably light at a wavelength of 180 to 300 nm) having a wavelength of 300 nm or less can be used. Examples of the light at a wavelength of 300 nm or less include KrF-rays (wavelength: 248 nm) and ArF-rays (wavelength: 193 nm), and the KrF-rays (wavelength: 248 nm) are preferable. In addition, a long-wave light source of 300 nm or more can be used.

Moreover, during exposure, the exposure may be performed by continuous irradiation with light or may be performed by pulsed irradiation (pulse exposure). In addition, the pulse exposure is an exposing method in a mode in which irradiation with light and rest are repeated in a short cycle (for example, a millisecond level or lower) to perform exposure.

The irradiation amount (exposure amount) is, for example, preferably 0.03 to 2.5 J/cm², and more preferably 0.05 to 1.0 J/cm². The oxygen concentration during the exposure can be appropriately selected, and the exposure may also be performed, for example, in a low-oxygen atmosphere having an oxygen concentration of 19% by volume or less (for example, 15% by volume, 5% by volume, and substantially oxygen-free) or in a high-oxygen atmosphere having an oxygen concentration of more than 21% by volume (for example, 22% by volume, 30% by volume, and 50% by volume), in addition to an atmospheric air. In addition, the exposure illuminance can be appropriately set, and can be usually selected from a range of 1,000 W/m² to 100,000 W/m² (for example, 5,000 W/m², 15,000 W/m², or 35,000 W/m²). Appropriate conditions of each of the oxygen concentration and the illuminance of exposure energy may be combined, and for example, a combination of an oxygen concentration of 10% by volume and an illuminance of 10,000 W/m², a combination of an oxygen concentration of 35% by volume and an illuminance of 20,000 W/m², or the like is available.

The non-exposed portion of the composition layer for forming an optical filter can be removed by development using a developer. Examples of the developer include an organic solvent and an alkali developer, and the alkali developer is preferably used. As the alkali developer, an alkaline aqueous solution (alkali developer) in which an alkaline agent is diluted with pure water is preferable. Examples of the alkali agent include organic alkaline compounds such as ammonia, ethylamine, diethylamine, dimethylethanolamine, diglycol amine, diethanolamine, hydroxyamine, ethylenediamine, tetramethylammonium hydroxide, tetraethylammonium hydroxide, tetrapropylammonium hydroxide, tetrabutylammonium hydroxide, ethyltrimethylammonium hydroxide, benzyltrimethylammonium hydroxide, dimethylbis(2-hydroxyethyl)ammonium hydroxide, choline, pyrrole, piperidine, and 1,8-diazabicyclo-[5.4.0]-7-undecene, and inorganic alkaline compounds such as sodium hydroxide, potassium hydroxide, sodium carbonate, sodium hydrogen carbonate, sodium silicate, and sodium metasilicate. In consideration of environmental aspects and safety aspects, the alkali agent is preferably a compound having a high molecular weight. A concentration of the alkali agent in the alkaline aqueous solution is preferably 0.001% to 10% by mass, and more preferably 0.01% to 1% by mass. In addition, the developer may further contain a surfactant.

In a case where the composition layer for forming an optical filter is exposed two or more times, the composition layer for forming an optical filter before development may be exposed two or more times, but it is preferable that the composition layer for forming an optical filter before development is subjected to first exposure and the composition layer for forming an optical filter after development is subjected to second exposure. In addition, it is also preferable that the first exposure is performed with light at a wavelength of more than 350 nm and 380 nm or less, and the second exposure is performed with light at a wavelength of 254 to 350 nm.

### (Composition for Forming Optical Filter)

The composition for forming an optical filter, which is used for forming the optical filter 30, preferably includes a coloring material, a resin, and a solvent.

### - Coloring Material -

Examples of the coloring material include the above-described coloring materials. A content of the coloring material in the total solid content of the composition for forming an optical filter is preferably 20% to 90% by mass. A lower limit thereof is preferably 30% by mass or more, more preferably 40% by mass or more, and still more preferably 50% by mass or more. An upper limit of the content is preferably 80% by mass or less, and more preferably 70% by mass or less.

### - Resin -

The composition for forming an optical filter preferably includes a resin. The resin is blended for a use in dispersing a pigment and the like in the composition for forming an optical filter, or for a use as a binder. Furthermore, mainly, the resin used for dispersing a pigment and the like in the composition for forming an optical filter is also referred to as a dispersant. It should be noted that such a use of the resin are merely exemplary, and the resin can also be used for purposes other than such a use.

A weight-average molecular weight of the resin is preferably 3,000 to 2,000,000. An upper limit thereof is preferably 1,000,000 or less, and more preferably 500,000 or less. A lower limit of the weight-average molecular weight is preferably 4,000 or more, and more preferably 5,000 or more.

Examples of the resin include a (meth)acrylic resin, an epoxy resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamide resin, a polyamideimide resin, a polyolefin resin, a cyclic olefin resin, a polyester resin, a styrene resin, a vinyl acetate resin, a polyvinyl alcohol resin, a polyvinyl acetal resin, a polyurethane resin, and a polyurea resin. These resins may be used singly or as a mixture of two or more kinds thereof. From the viewpoint of improving the heat resistance, a norbornene resin is preferable as the cyclic olefin resin. Examples of a commercially available product of the norbornene resin include ARTON series (for example, ARTON F4520) manufactured by JSR Corporation. In addition, as the resin, the resins described in Examples of WO2016/088645A, the resins described in JP2017-057265A, the resins described in JP2017-032685A, the resins described in JP2017-075248A, the resins described in JP2017-066240A, the resins described in JP2017-167513A, the resins described in JP2017-173787A, the resins described in paragraph Nos. 0041 to 0060 of JP2017-206689A, the resins described in paragraph Nos. 0022 to 0071 of JP2018-010856A, the block polyisocyanate resins described in JP2016-222891A, the resins described in JP2020-122052A, the resins described in JP2020-111656A, the resins described in JP2020-139021A, or the resins including a constitutional unit having a ring structure in the main chain and a constitutional unit having a biphenyl group in the side chain, described in JP2017-138503A can also be used. In addition, as the resin, a resin having a fluorene skeleton can also be preferably used. With regard to the resin having a fluorene skeleton, reference can be made to the description in US2017/0102610A, the contents of which are incorporated herein by reference. In addition, as the resin, the resins described in paragraphs 0199 to 0233 of JP2020-186373A, the alkali-soluble resins described in JP2020-186325A, and the resins represented by Formula 1, described in KR10-2020-0078339A can also be used.

As the resin, a resin having an acid group is preferably used. Examples of the acid group include a carboxy group, a phosphoric acid group, a sulfo group, and a phenolic hydroxy group. These acid groups may be used alone or in combination of two or more kinds thereof. The resin having an acid group can be used, for example, as an alkali-soluble resin. An acid value of the resin having an acid group is preferably 30 to 500 mgKOH/g. A lower limit thereof is preferably 50 mgKOH/g or more, and more preferably 70 mgKOH/g or more. An upper limit of the acid value is preferably 400 mgKOH/g or less, more preferably 200 mgKOH/g or less, still more preferably 150 mgKOH/g or less, and most preferably 120 mgKOH/g or less.

The resin also preferably includes a resin including a repeating unit having a polymerizable group. Examples of the polymerizable group include an ethylenically unsaturated bond-containing group.

As the resin, a resin (hereinafter also referred to as a resin Ac) having an aromatic carboxy group is also preferably used. The resin Ac may include the aromatic carboxy group in the main chain of the repeating unit, or in the side chain of the repeating unit. It is preferable that the aromatic carboxy group is included in the main chain of the repeating unit. Furthermore, in the present specification, the aromatic carboxy group is a group having a structure in which one or more carboxyl groups are bonded to an aromatic ring. In the aromatic carboxy group, the number of carboxyl groups bonded to an aromatic ring is preferably 1 to 4, and more preferably 1 or 2.

The composition for forming an optical filter preferably contains a resin as a dispersant. Examples of the dispersant include an acidic dispersant (acidic resin) and a basic dispersant (basic resin). Here, the acidic dispersant (acidic resin) represents a resin in which the amount of the acid group is larger than the amount of the basic group. The acidic dispersant (acidic resin) is preferably a resin in which the amount of the acid group is 70% by mole or more in a case where a total amount of the acid group and the basic group is 100% by mole. The acid group included in the acidic dispersant (acidic resin) is preferably a carboxy group. An acid value of the acidic dispersant (acidic resin) is preferably 10 to 105 mgKOH/g. In addition, the basic dispersant (basic resin) represents a resin in which the amount of the basic group is larger than the amount of the acid group. The basic dispersant (basic resin) is preferably a resin in which the amount of the basic group is more than 50% by mole in a case where the total amount of the acid group and the basic group is 100% by mole. The basic group included in the basic dispersant is preferably an amino group.

It is also preferable that the resin used as a dispersant is a graft resin. With regard to details of the graft resin, reference can be made to the description in paragraph Nos. 0025 to 0094 of JP2012-255128A, the contents of which are incorporated herein by reference.

It is also preferable that the resin used as a dispersant is a resin (resin Ac) having an aromatic carboxy group. Examples of the resin having an aromatic carboxy group include those described above.

It is also preferable that the resin used as a dispersant is a polyimine-based dispersant including a nitrogen atom in at least one of the main chain or the side chain. As the polyimine-based dispersant, a resin having a main chain which has a partial structure having a functional group of pKa 14 or less, and a side chain which has 40 to 10,000 atoms, in which at least one of the main chain or the side chain has a basic nitrogen atom, is preferable. The basic nitrogen atom is not particularly limited as long as it is a nitrogen atom exhibiting basicity. With regard to the polyimine-based dispersant, reference can be made to the description in paragraph Nos. 0022 to 0097 of JP2009-203462A and paragraph Nos. 0102 to 0166 of JP2012-255128A, the contents of which are incorporated herein by reference.

It is also preferable that the resin used as a dispersant is a resin having a structure in which a plurality of polymer chains are bonded to a core part. Examples of such a resin include dendrimers (including star polymers). In addition, specific examples of the dendrimer include the polymer compounds C-1 to C-31 described in paragraph Nos. 0196 to 0209 of JP2013-043962A.

It is also preferable that the resin used as a dispersant is a resin including a repeating unit having an ethylenically unsaturated bond-containing group in a side chain thereof. A content of the repeating unit having an ethylenically unsaturated bond-containing group in the side chain is preferably 10% by mole or more, more preferably 10 to 80% by mole, and still more preferably 20 to 70% by mole with respect to all the repeating units of the resin.

As a dispersant, the resins described in JP2018-087939A, the block copolymers (EB-1) to (EB-9) described in paragraph Nos. 0219 to 0221 of JP6432077B, the polyethyleneimine having a polyester side chain, described in WO2016/104803A, the block copolymers described in WO2019/125940A, the block polymers having an acrylamide structural unit, described in JP2020-066687A, the block polymers having an acrylamide structural unit, described in JP2020-066688A, the dispersants described in WO2016/104803A, or the like can also be used.

A commercially available product is also available as the dispersant, and specific examples thereof include DISPERBYK series manufactured by BYK Chemie Japan, Solsperse series manufactured by Lubrizol Japan Ltd., Efka series manufactured by BASF SE, and AJISPER series manufactured by Ajinomoto Fine-Techno Co., Inc. In addition, the products described in paragraph No. 0129 of JP2012-137564A and the products described in paragraph No. 0235 of JP2017-194662A can also be used as the dispersant.

A content of the resin in the total solid content of the composition for forming an optical filter is preferably 1% to 60% by mass. A lower limit thereof is preferably 5% by mass or more, more preferably 10% by mass or more, still more preferably 15% by mass or more, and particularly preferably 20% by mass or more. An upper limit of the content is preferably 50% by mass or less, and more preferably 40% by mass or less. The composition for forming an optical filter may include only one kind or two or more kinds of the resins. In a case where two or more kinds of the resins are included, a total amount thereof is preferably within the range.

### - Solvent -

The composition for forming an optical filter preferably includes a solvent. Examples of the solvent include an organic solvent. Basically, the type of the solvent is not particularly limited as long as it satisfies the solubility of each component or the coating properties of the composition. Examples of the organic solvent include an ester-based solvent, a ketone-based solvent, an alcohol-based solvent, an amide-based solvent, an ether-based solvent, and a hydrocarbon-based solvent. With regard to the details of the organic solvent, reference can be made to paragraph No. 0223 of WO2015/166779A, the contents of which are incorporated herein by reference. In addition, an ester-based solvent in which a cyclic alkyl group is substituted or a ketone solvent in which a cyclic alkyl group is substituted can also be preferably used. Specific examples of the organic solvent include polyethylene glycol monomethyl ether, dichloromethane, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, 3-pentanone, 4-heptanone, cyclohexanone, 2-methylcyclohexanone, 3-methylcyclohexanone, 4-methylcyclohexanone, cycloheptanone, cyclooctanone, cyclohexyl acetate, cyclopentanone, ethylcarbitol acetate, butylcarbitol acetate, propylene glycol monomethyl ether, propylene glycol monomethyl ether acetate, 3-methoxy-N,N-dimethylpropanamide, 3-butoxy-N,N-dimethylpropanamide, propylene glycol diacetate, 3-methoxybutanol, methyl ethyl ketone, γ-butyrolactone, sulfolane, anisole, 1,4-diacetoxybutane, diethylene glycol monoethyl ether acetate, butane diacetate-1,3-diyl, dipropylene glycol methyl ether acetate, diacetone alcohol (also known as diacetone alcohol or 4-hydroxy-4-methyl-2-pentanone), 2-methoxypropyl acetate, 2-methoxy-1-propanol, and isopropyl alcohol. It should be noted that it may be favorable that a content of aromatic hydrocarbons (such as benzene, toluene, xylene, and ethylbenzene) as the organic solvent is low (for example, 50 parts per million (ppm) by mass or less, 10 ppm by mass or less, or 1 ppm by mass or less with respect to the total amount of the organic solvent) in consideration of environmental aspects and the like.

It is also preferable that the composition for forming an optical filter includes a solvent having a boiling point of 110°C or lower. Examples of the solvent having a boiling point of 110°C or lower include acetone, methyl ethyl ketone, ethyl acetate, tetrahydrofuran, cyclopentyl methyl ether, methanol, ethanol, 2-propanol, hexane, and cyclohexane.

A content of the solvent in the composition for forming an optical filter is preferably 10% to 95% by mass, more preferably 20% to 90% by mass, and still more preferably 30% to 90% by mass.

### - Pigment Derivative -

The composition for forming an optical filter can contain a pigment derivative. The pigment derivative is used, for example, as a dispersion aid. The dispersion aid is a material for increasing the dispersibility of the pigment in the composition for forming an optical filter. Examples of the pigment derivative include a compound having at least one kind of structure selected from the group consisting of a coloring agent structure and a triazine structure, and an acid group or a basic group.

Examples of the coloring agent structure include a quinoline coloring agent structure, a benzimidazolone coloring agent structure, a benzoisoindole coloring agent structure, a benzothiazole coloring agent structure, an iminium coloring agent structure, a squarylium coloring agent structure, a croconium coloring agent structure, an oxonol coloring agent structure, a pyrrolopyrrole coloring agent structure, a diketopyrrolopyrrole coloring agent structure, an azo coloring agent structure, an azomethine coloring agent structure, a phthalocyanine coloring agent structure, a naphthalocyanine coloring agent structure, an anthraquinone coloring agent structure, a quinacridone coloring agent structure, a dioxazine coloring agent structure, a perinone coloring agent structure, a perylene coloring agent structure, a thiazine indigo coloring agent structure, a thioindigo coloring agent structure, an isoindoline coloring agent structure, an isoindolinone coloring agent structure, a quinophthalone coloring agent structure, a dithiol coloring agent structure, a triarylmethane coloring agent structure, and a pyrromethene coloring agent structure.

Examples of the acid group included in the pigment derivative include a carboxy group, a sulfo group, a phosphoric acid group, a boronic acid group, an imidic acid group, and salts of these. Examples of atoms or atomic groups constituting the salts include alkali metal ions (Li⁺, Na⁺, K⁺, and the like), alkaline earth metal ions (Ca²⁺, Mg²⁺, and the like), ammonium ions, imidazolium ions, pyridinium ions, and phosphonium ions.

Examples of the basic group included in the pigment derivative include an amino group, a pyridinyl group or a salt thereof, a salt of an ammonium group, and a phthalimidomethyl group. Examples of the atom or atomic group constituting the salt include a hydroxide ion, a halogen ion, a carboxylate ion, a sulfonate ion, and a phenoxide ion.

As the pigment derivative, a pigment derivative having excellent visible transparency (hereinafter also referred to as a transparent pigment derivative) can be used. A maximum value (εmax) of the molar absorption coefficient of the transparent pigment derivative in a wavelength range of 400 to 700 nm is preferably 3,000 L·mol⁻¹·cm⁻¹ or less, more preferably 1,000 L·mol⁻¹·cm⁻¹ or less, and still more preferably 100 L·mol⁻¹·cm⁻¹ or less. A lower limit of εmax is, for example, 1 L·mol⁻¹·cm⁻¹ or more, and may be 10 L·mol⁻¹·cm⁻¹ or more.

Specific examples of the pigment derivative include the compounds described in JP1981-118462A (JP-S56-118462A), the compounds described in JP1988-264674A (JP-S63-264674A), the compounds described in JP1989-217077A (JP-H01-217077A), the compounds described in JP1991-009961A (JP-H03-009961A), the compounds described in JP1991-026767A (JP-H03-026767A), the compounds described in JP1991-153780A (JP-H03-153780A), the compounds described in JP1991-045662A (JP-H03-045662A), the compounds described in JP1992-285669A (JP-H04-285669A), the compounds described in JP1994-145546A (JP-H06-145546A), the compounds described in JP1994-212088A (JP-H06-212088A), the compounds described in JP1994-240158A (JP-H06-240158A), the compounds described in JP1998-030063A (JP-H10-030063A), the compounds described in JP1998-195326A (JP-H10-195326A), the compounds described in paragraph Nos. 0086 to 0098 of WO2011/024896A, the compounds described in paragraph Nos. 0063 to 0094 of WO2012/102399A, the compounds described in paragraph No. 0082 of WO2017/038252A, the compounds described in paragraph No. 0171 of JP2015-151530A, the compounds described in paragraph Nos. 0162 to 0183 of JP2011-252065A, the compounds described in JP2003-081972A, the compounds described in JP5299151B, the compounds described in JP2015-172732A, the compounds described in JP2014-199308A, the compounds described in JP2014-085562A, the compounds described in JP2014-035351A, the compounds described in JP2008-081565A, the compounds described in JP2019-109512A, the compounds described in JP2019-133154A, diketopyrrolopyrrole compounds having a thiol linking group, described in WO2020/002106A, and benzimidazolone compounds or salts thereof, described in JP2018-168244A.

A content of the pigment derivative is preferably 1 to 30 parts by mass, and more preferably 3 to 20 parts by mass with respect to 100 parts by mass of the pigment. The composition for forming an optical filter may include only one kind or two or more kinds of the pigment derivatives. In a case where two or more kinds of the pigment derivatives are included, a total amount thereof is preferably within the range.

### - Polymerizable Compound -

The composition for forming an optical filter preferably contains a polymerizable compound. As the polymerizable compound, a known compound which is crosslinkable by a radical, an acid, or heat can be used. The polymerizable compound is preferably a compound having an ethylenically unsaturated bond-containing group. Examples of the ethylenically unsaturated bond-containing group include a vinyl group, a (meth)allyl group, and a (meth)acryloyl group. The polymerizable compound is preferably a radically polymerizable compound.

Any chemical forms of a monomer, a prepolymer, an oligomer, and the like may be used as the polymerizable compound, but a monomer is preferable. A molecular weight of the polymerizable compound is preferably 100 to 3,000. An upper limit thereof is more preferably 2,000 or less, and still more preferably 1,500 or less. A lower limit of the molecular weight is more preferably 150 or more, and still more preferably 250 or more.

The polymerizable compound is preferably a compound including 3 or more ethylenically unsaturated bond-containing groups, more preferably a compound including 3 to 15 ethylenically unsaturated bond-containing groups, and still more preferably a compound including 3 to 6 ethylenically unsaturated bond-containing groups. In addition, the polymerizable compound is preferably a trifunctional to pentadecafunctional (meth)acrylate compound, and more preferably a trifunctional to hexafunctional (meth)acrylate compound. Specific examples of the polymerizable compound include the compounds described in paragraph Nos. 0095 to 0108 of JP2009-288705A, paragraph 0227 of JP2013-029760A, paragraph Nos. 0254 to 0257 of JP2008-292970A, paragraph Nos. 0034 to 0038 of JP2013-253224A, paragraph No. 0477 of JP2012-208494A, JP2017-048367A, JP6057891B, and JP6031807B, the contents of which are incorporated herein by reference.

As the polymerizable compound, dipentaerythritol tri(meth)acrylate (as a commercially available product, KAYARAD D-330 manufactured by Nippon Kayaku Co., Ltd.), dipentaerythritol tetra(meth)acrylate (as a commercially available product, KAYARAD D-320 manufactured by Nippon Kayaku Co., Ltd.), dipentaerythritol penta(meth)acrylate (as a commercially available product, KAYARAD D-310 manufactured by Nippon Kayaku Co., Ltd.), dipentaerythritol hexa(meth)acrylate (as a commercially available product, KAYARAD DPHA manufactured by Nippon Kayaku Co., Ltd., NK ESTER A-DPH-12E manufactured by Shin-Nakamura Chemical Co., Ltd.), or a compound having a structure in which these (meth)acryloyl groups are bonded through an ethylene glycol and/or a propylene glycol residue (for example, SR454 and SR499 which are commercially available products from Sartomer Company Inc.) is preferable. In addition, as the polymerizable compound, diglycerin ethylene oxide (EO)-modified (meth)acrylate (as a commercially available product, M-460 manufactured by Toagosei Co., Ltd.), pentaerythritol tetraacrylate (NK ESTER A-TMMT manufactured by Shin-Nakamura Chemical Co., Ltd.), 1,6-hexanediol diacrylate (KAYARAD HDDA manufactured by Nippon Kayaku Co., Ltd.), RP-1040 (manufactured by Nippon Kayaku Co., Ltd.), ARONIX TO-2349 (manufactured by Toagosei Co., Ltd.), NK OLIGO UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600, and LINC-202UA (manufactured by KYOEISHA CHEMICAL Co., LTD.), 8UH-1006 and 8UH-1012 (manufactured by Taisei Fine Chemical Co., Ltd.), Light Acrylate POB-A0 (manufactured by KYOEISHA CHEMICAL Co., Ltd.), or the like can also be used.

In the polymerizable compound, a compound having an acid group can also be used. By using a polymerizable compound having an acid group, the polymerizable compound in a non-exposed portion is easily removed during development and the generation of a development residue can be suppressed. Examples of the acid group include a carboxy group, a sulfo group, and a phosphoric acid group, and the carboxy group is preferable. Examples of the polymerizable compound having an acid group include succinic acid-modified dipentaerythritol penta(meth)acrylate. Examples of a commercially available product of the polymerizable compound having an acid group include ARONIX M-510, M-520, and ARONIX TO-2349 (manufactured by Toagosei Co., Ltd.). An acid value of the polymerizable compound having an acid group is preferably 0.1 to 40 mgKOH/g, and more preferably 5 to 30 mgKOH/g. In a case where the acid value of the polymerizable compound is 0.1 mgKOH/g or more, the solubility in a developer is good, and in a case where the acid value of the polymerizable compound is 40 mgKOH/g or less, it is advantageous in the production and the handling.

In the polymerizable compound, a compound having a caprolactone structure can also be used. Examples of a commercially available product of the polymerizable compound having a caprolactone structure include KAYARAD DPCA-20, DPCA-30, DPCA-60, and DPCA-120 (all manufactured by Nippon Kayaku Co., Ltd.).

In the polymerizable compound, a polymerizable compound having an alkyleneoxy group can also be used. The polymerizable compound having an alkyleneoxy group is preferably a polymerizable compound having an ethyleneoxy group and/or a propyleneoxy group, more preferably a polymerizable compound having an ethyleneoxy group, and still more preferably a 3-functional to 6-functional (meth)acrylate compound having 4 to 20 ethyleneoxy groups. Examples of a commercially available product of the polymerizable compound having an alkyleneoxy group include SR-494 manufactured by Sartomer Company Inc., which is a tetrafunctional (meth)acrylate having 4 ethyleneoxy groups, and KAYARAD TPA-330 manufactured by Nippon Kayaku Co., Ltd., which is a trifunctional (meth)acrylate having 3 isobutyleneoxy groups.

In the polymerizable compound, a polymerizable compound having a fluorene skeleton can also be used. Examples of a commercially available product of the polymerizable compound having a fluorene skeleton include OGSOL EA-0200, EA-0300 (manufactured by Osaka Gas Chemicals Co., Ltd., a (meth)acrylate monomer having a fluorene skeleton).

As the polymerizable compound, a compound which does not substantially include environmentally regulated substances such as toluene is also preferably used. Examples of a commercially available product of such a compound include KAYARAD DPHA LT and KAYARAD DPEA-12 LT (manufactured by Nippon Kayaku Co., Ltd.).

A content of the polymerizable compound in the total solid content of the composition for forming an optical filter is preferably 0.1% to 50% by mass. A lower limit thereof is preferably 0.5% by mass or more, more preferably 1% by mass or more, and still more preferably 3% by mass or more. An upper limit of the content is preferably 40% by mass or less, more preferably 30% by mass or less, and still more preferably 25% by mass or less. The composition for forming an optical filter may include only one kind or two or more kinds of the polymerizable compounds. In a case where two or more kinds of the polymerizable compounds are included, a total amount thereof is preferably within the range.

### - Photopolymerization Initiator -

The composition for forming an optical filter preferably contains a photopolymerization initiator. The photopolymerization initiator is not particularly limited and can be appropriately selected from known photopolymerization initiators. For example, a compound having photosensitivity to light in a range from an ultraviolet range to a visible range is preferable. The photopolymerization initiator is preferably a photoradical polymerization initiator.

Examples of the photopolymerization initiator include a halogenated hydrocarbon derivative (for example, a compound having a triazine skeleton and a compound having an oxadiazole skeleton), an acylphosphine compound, a hexaarylbiimidazole compound, an oxime compound, an organic peroxide, a thio compound, a ketone compound, an aromatic onium salt, an α-hydroxyketone compound, and an α-aminoketone compound. From the viewpoint of the exposure sensitivity, as the photopolymerization initiator, a trihalomethyltriazine compound, a benzyldimethylketal compound, an α-hydroxyketone compound, an α-aminoketone compound, an acylphosphine compound, a phosphine oxide compound, a metallocene compound, an oxime compound, a hexaarylbiimidazole compound, an onium compound, a benzothiazole compound, a benzophenone compound, an acetophenone compound, a cyclopentadiene-benzene-iron complex, a halomethyl oxadiazole compound, or a 3-aryl-substituted coumarin compound is preferable, a compound selected from the oxime compound, the α-hydroxyketone compound, the α-aminoketone compound, and the acylphosphine compound is more preferable, and the oxime compound is still more preferable. In addition, examples of the photopolymerization initiator include the compounds described in paragraph Nos. 0065 to 0111 of JP2014-130173A, the compounds described in JP6301489B, the peroxide-based photopolymerization initiators described in MATERIAL STAGE, p. 37 to 60, vol. 19, No. 3, 2019, the photopolymerization initiators described in WO2018/221177A, the photopolymerization initiators described in WO2018/110179A, the photopolymerization initiators described in JP2019-043864A, the photopolymerization initiators described in JP2019-044030A, the peroxide initiators described in JP2019-167313A, the aminoacetophenone-based initiators described in JP2020-055992A, the oxime-based photopolymerization initiators described in JP2013-190459A, the polymers described in JP2020-172619A, the compound represented by Formula 1 described in WO2020/152120A, and the compounds described in JP2021-181406A, the contents of which are incorporated herein by reference.

Examples of a commercially available product of the α-hydroxyketone compound include Omnirad 184, Omnirad 1173, Omnirad 2959, and Omnirad 127 (all manufactured by IGM Resins B.V), and Irgacure 184, Irgacure 1173, Irgacure 2959, and Irgacure 127 (all manufactured by BASF). Examples of a commercially available product of the α-aminoketone compound include Omnirad 907, Omnirad 369, Omnirad 369E, and Omnirad 379EG (all manufactured by IGM Resins B.V), and Irgacure 907, Irgacure 369, Irgacure 369E, and Irgacure 379EG (all manufactured by BASF). Examples of a commercially available product of the acylphosphine compound include Omnirad 819 and Omnirad TPO (both of which are manufactured by IGM Resins B.V), and Irgacure 819 and Irgacure TPO (both of which are manufactured by BASF).

Examples of the oxime compound include the compounds described in JP2001-233842A, the compounds described in JP2000-080068A, the compounds described in JP2006-342166A, the compounds described in J. C. S. Perkin II (1979, pp. 1653 to 1660), the compounds described in J. C. S. Perkin II (1979, pp. 156 to 162), the compounds described in Journal of Photopolymer Science and Technology (1995, pp. 202 to 232), the compounds described in JP2000-066385A, the compounds described in JP2004-534797A, the compounds described in JP2006-342166A, the compounds described in JP2017-019766A, the compounds described in JP6065596B, the compounds described in WO2015/152153A, the compounds described in WO2017/051680A, the compounds described in JP2017-198865A, the compounds described in paragraph Nos. 0025 to 0038 of WO2017/164127A, the compounds described in WO2013/167515A, the compounds described in JP5430746B, the compounds described in JP5647738B, the compounds represented by General Formula (1) and the compounds described in paragraph Nos. 0022 to 0024 of JP2021-173858A, the compounds represented by General Formula (1) and the compounds described in paragraph Nos. 0117 to 0120 of JP2021-170089A, the compounds described in JP2014-137466A, the compounds described in JP6636081B, the compounds described in KR10-2016-0109444A, the fluorenylaminoketone photoinitiators described in JP2020-507664A, the oxime ester compounds described in WO2021/023144A, the compounds described in WO2013/083505A, the compounds described in JP2010-262028A, the compounds 24 and 36 to 40 described in JP2014-500852A, the compounds (C-3) described in JP2013-164471A, the compounds described in paragraph Nos. 0031 to 0047 of JP2013-114249A, paragraph Nos. 0008 to 0012 and 0070 to 0079 of JP2014-137466A, and paragraph Nos. 0007 to 0025 of JP4223071B, OE-01 to OE-75 described in WO2015/036910A, and the compounds described in WO2019/088055A. Specific examples of the oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluene sulfonyloxy)iminobutan-2-one, 2-ethoxycarbonyloxyimino-1-phenylpropan-1-one, and 1-[4-(phenylthio)phenyl]-3-cyclohexyl-propane-1,2-dione-2-(O-acetyloxime). Examples of a commercially available product thereof include Irgacure OXE01, Irgacure OXE02, Irgacure OXE03, and Irgacure OXE04 (all manufactured by BASF SE), TR-PBG-301, TR-PBG-304, and TR-PBG-327 (all manufactured by TRONLY LIMITED), ADEKA OPTOMER N-1919 (manufactured by ADEKA Corporation, the photopolymerization initiator 2 described in JP2012-014052A), and ADEKA ARKLS NCI-730, NCI-831, and NCI-930 (all manufactured by ADEKA Corporation).

A content of the photopolymerization initiator in the total solid content of the composition for forming an optical filter is preferably 0.1% to 30% by mass. A lower limit thereof is preferably 0.5% by mass or more, and more preferably 1% by mass or more. An upper limit of the content is preferably 20% by mass or less, and more preferably 15% by mass or less. The composition for forming an optical filter may include only one kind or two or more kinds of the photopolymerization initiators. In a case where two or more kinds of the photopolymerization initiators are included, a total amount thereof is preferably within the range.

### - Compound Having Cyclic Ether Group -

The composition for forming an optical filter can contain a compound having a cyclic ether group. Examples of the cyclic ether group include an epoxy group and an oxetanyl group. The compound having a cyclic ether group is preferably a compound having an epoxy group (hereinafter also referred to as an "epoxy compound"). As the compound having a cyclic ether group, the compounds described in paragraph Nos. 0034 to 0036 of JP2013-011869A, the compounds described in paragraph Nos. 0147 to 0156 of JP2014-043556A, the compounds paragraph Nos. 0085 to 0092 of JP2014-089408A, and the compounds described in JP2017-179172A can also be used. Examples of a commercially available product of the compound having a cyclic ether group include EHPE3150 (manufactured by Daicel Chemical Industries, Ltd.), EPICLON N-695 (manufactured by DIC Corporation), MARPROOF G-0150M, G-0105SA, G-0130SP, G-0250SP, G-1005S, G-1005SA, G-1010S, G-2050M, G-01100, and G-01758 (all manufactured by NOF Corporation, epoxy group containing polymer). A content of the compound having a cyclic ether group in the total solid content of the composition for forming an optical filter is preferably 0.1% to 20% by mass. A lower limit thereof is, for example, preferably 0.5% by mass or more, and more preferably 1% by mass or more. An upper limit of the content is, for example, preferably 15% by mass or less, and more preferably 10% by mass or less. The composition for forming an optical filter may include only one kind or two or more kinds of the compounds having a cyclic ether group. In a case where two or more kinds of the compounds having a cyclic ether group are included, a total amount thereof is preferably within the range.

### - Curing Accelerator -

The composition for forming an optical filter can contain a curing accelerator. Examples of the curing accelerator include a thiol compound, a methylol compound, an amine compound, a phosphonium salt compound, an amidine salt compound, an amide compound, a base generator, an isocyanate compound, an alkoxysilane compound, and an onium salt compound. Specific examples of the curing accelerator include the compounds described in paragraph Nos. 0094 to 0097 of WO2018/056189A, the compounds described in paragraph Nos. 0246 to 0253 of JP2015-034963A, the compounds described in paragraph Nos. 0186 to 0251 of JP2013-041165A, the ionic compounds described in JP2014-055114A, the compounds described in paragraph Nos. 0071 to 0080 of JP2012-150180A, the alkoxysilane compounds having an epoxy group described in JP2011-253054A, the compounds described in paragraph Nos. 0085 to 0092 of JP5765059B, the carboxy group-containing epoxy curing agent described in JP2017-036379A, and the compounds described in JP2021-181406A. A content of the curing accelerator in the total solid content of the composition for forming an optical filter is preferably 0.3% to 8.9% by mass, and more preferably 0.8% to 6.4% by mass.

### - Ultraviolet Absorber -

The composition for forming an optical filter can contain an ultraviolet absorber. Examples of the ultraviolet absorber include a conjugated diene compound, an aminodiene compound, a salicylate compound, a benzophenone compound, a benzotriazole compound, an acrylonitrile compound, a hydroxyphenyltriazine compound, an indole compound, a triazine compound, and a dibenzoyl compound. Specific examples of such a compound include the compounds described in paragraph Nos. 0038 to 0052 of JP2009-217221A, paragraph Nos. 0052 to 0072 of JP2012-208374A, paragraph Nos. 0317 to 0334 of JP2013-068814A, and paragraph Nos. 0061 to 0080 of JP2016-162946A, the contents of which are incorporated herein by reference. Examples of a commercially available product of the ultraviolet absorber include UV-503 (manufactured by Daito Chemical Co., Ltd.), Tinuvin series and Uvinul series manufactured by BASF SE, and Sumisorb series manufactured by Sumika Chemtex Co., Ltd. In addition, examples of the benzotriazole compound include MYUA series manufactured by Miyoshi Oil & Fat Co., Ltd. (The Chemical Daily, February 1, 2016). In addition, as the ultraviolet absorber, the compounds described in paragraph Nos. 0049 to 0059 of JP6268967B, the compounds described in paragraph Nos. 0059 to 0076 of WO2016/181987A, the thioaryl group-substituted benzotriazole type ultraviolet absorbers described in WO2020/137819A, or the reactive triazine ultraviolet absorbers described in JP2021-178918A can also be used. A content of the ultraviolet absorber in the total solid content of the composition for forming an optical filter is preferably 0.01% to 10% by mass, and more preferably 0.01% to 5% by mass. The composition for forming an optical filter may include only one kind or two or more kinds of the ultraviolet absorbers. In a case where two or more kinds of the ultraviolet absorbers are included, a total amount thereof is preferably within the range.

### - Polymerization Inhibitor -

The composition for forming an optical filter can contain a polymerization inhibitor. Examples of the polymerization inhibitor include hydroquinone, p-methoxyphenol, di-tert-butyl-p-cresol, pyrogallol, tert-butylcatechol, benzoquinone, 4,4'-thiobis(3-methyl-6-tertbutylphenol), 2,2'-methylenebis(4-methyl-6-t-butylphenol), and an N-nitrosophenylhydroxylamine salt (for example, an ammonium salt and a cerium salt). Among these, p-methoxyphenol is preferable. A content of the polymerization inhibitor in the total solid content of the composition for forming an optical filter is preferably 0.0001% to 5% by mass. The composition for forming an optical filter may include only one kind or two or more kinds of the polymerization inhibitors. In a case where two or more kinds of the polymerization inhibitors are included, a total amount thereof is preferably within the range.

### - Silane Coupling Agent -

The composition for forming an optical filter can contain a silane coupling agent. Examples of the silane coupling agent include the compounds described in paragraph Nos. 0018 to 0036 of JP2009-288703A and the compounds described in paragraph Nos. 0056 to 0066 of JP2009-242604A, the contents of which are incorporated herein by reference. A content of the silane coupling agent in the total solid content of the composition for forming an optical filter is preferably 0.01% to 15% by mass, and more preferably 0.05% to 10% by mass. The composition for forming an optical filter may include only one kind or two or more kinds of the silane coupling agents. In a case where two or more kinds of the silane coupling agents are included, a total amount thereof is preferably within the range.

### - Surfactant -

The composition for forming an optical filter can contain a surfactant. As the surfactant, various surfactants such as a fluorine-based surfactant, a nonionic surfactant, a cationic surfactant, an anionic surfactant, or a silicone-based surfactant can be used. The surfactant is preferably the silicone-based surfactant or the fluorine-based surfactant. With regard to the surfactant, reference can be made to the surfactants described in paragraph Nos. 0238 to 0245 of WO2015/166779A, the contents of which are incorporated herein by reference.

As the fluorine-based surfactant, the surfactants described in paragraph Nos. 0060 to 0064 of JP2014-041318A (paragraph Nos. 0060 to 0064 of the corresponding WO2014/017669A), the surfactants described in paragraph Nos. 0117 to 0132 of JP2011-132503A, the surfactants described in JP2020-008634A, the fluorine-based surfactants described in JP2016-216602A, the fluorine-containing surfactants described in paragraph Nos. 0016 to 0037 of JP2010-032698A, the fluorine-containing surfactants described in paragraph Nos. 0050 to 0090 and paragraph Nos. 0289 to 0295 of JP2010-164965A, and the fluorine-containing surfactants described in paragraph Nos. 0015 to 0158 of JP2015-117327A can also be used. In addition, from the viewpoint of environmental regulation, it is also preferable to use the surfactant described in WO2020/084854A as a substitute for a surfactant having a perfluoroalkyl group having 6 or more carbon atoms.

Examples of the nonionic surfactant include glycerol, trimethylolpropane, trimethylolethane, an ethoxylate and propoxylate thereof (for example, glycerol propoxylate or glycerol ethoxylate), polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilaurate, polyethylene glycol distearate, sorbitan fatty acid esters, PLURONIC L10, L31, L61, L62, 10R5, 17R2, and 25R2 (manufactured by BASF), TETRONIC 304, 701, 704, 901, 904, and 150R1 (manufactured by BASF), SOLSPERSE 20000 (manufactured by Lubrizol Corporation), NCW-101, NCW-1001, and NCW-1002 (all manufactured by FUJIFILM Wako Pure Chemical Corporation), PIONIN D-6112, D-6112-W, and D-6315 (all manufactured by Takemoto Oil&Fat Co., Ltd.), and OLFINE E1010 and SURFYNOL 104, 400, and 440 (all manufactured by Nissin Chemical Co., Ltd.).

Examples of the silicone-based surfactant include DOWSIL SH8400, SH 8400 FLUID, FZ-2122, 67 Additive, 74 Additive, M Additive, and SF 8419 OIL (all manufactured by Dow Toray Co., Ltd.), TSF-4300, TSF-4445, TSF-4460, and TSF-4452 (all manufactured by Momentive Performance Materials Inc.), KP-341, KF-6000, KF-6001, KF-6002, and KF-6003 (all manufactured by Shin-Etsu Chemical Co., Ltd.), and BYK-307, BYK-322, BYK-323, BYK-330, BYK-333, BYK-3760, and BYK-UV3510 (all manufactured by BYK-Chemie).

A content of the surfactant in the total solid content of the composition for forming an optical filter is preferably 0.001% by mass to 5.0% by mass, and more preferably 0.005% by mass to 3.0% by mass. The composition for forming an optical filter may include only one kind or two or more kinds of the surfactants. In a case where two or more kinds of the surfactants are included, a total amount thereof is preferably within the range.

### - Other Components -

The composition for forming an optical filter may contain, as necessary, an antioxidant, a potential antioxidant, a sensitizer, a curing accelerator, a filler, a thermal curing accelerator, a plasticizer, and other auxiliary agents (for example, conductive particles, an antifoaming agent, a flame retardant, a leveling agent, a peeling accelerator, an aromatic chemical, a surface tension adjuster, and a chain transfer agent). With regard to the details of the components, reference can be made to, for example, paragraph No. 0183 or subsequent paragraph Nos. of JP2012-003225A (corresponding to paragraph No. 0237 of US2013/0034812A), paragraph Nos. 0101 to 0104, and 0107 to 0109 of JP2008-250074A, and the like, the contents of which are incorporated herein by reference. In addition, as the antioxidant, the compounds described in paragraph Nos. 0023 to 0048 of JP6268967B, the compounds described in WO2017/006600A, the compounds described in WO2017/164024A, or the compounds described in KR10-2019-0059371A can also be used. Examples of the potential antioxidant include a compound with a moiety functioning as an antioxidant being protected with a protective group, in which the protective group leaves by heating the compound at 100°C to 250°C or by heating the compound at 80°C to 200°C in the presence of an acid/base catalyst, thus making the compound function as the antioxidant. Examples of the potential antioxidant include the compounds described in WO2014/021023A, WO2017/030005A, and JP2017-008219A. Examples of a commercially available product of the potential antioxidant include ADEKA ARKLS GPA-5001 (manufactured by ADEKA Corporation).

### <<Other Members>>

In the photodetector element of the embodiment of the present invention, a color filter may be further provided on the interlayer 20 in a region different from the region in which the above-described optical filter 30 is provided. That is, in a case where photodetector element further comprises a color filter, the color filter is provided on the interlayer 20 and on an optical path different from the optical filter 30.

The color filter is preferably a filter having at least one colored layer selected from the group consisting of a red layer, a blue layer, a green layer, a yellow layer, a magenta layer, and a cyan layer. The color filter may include colored layers with two or more colors or with only one color. It can be appropriately selected according to a use or purpose. For example, the color filter described in WO2019/039172A can be used.

Examples of a preferred aspect of the color filter include a filter having a red layer, a blue layer, and a green layer. Other preferred aspects of the color filter include a filter having a yellow layer, a magenta layer, and a cyan layer.

In a case where the color filter includes colored layers with two or more colors, the colored layers of the respective colors may be adjacent to each other or a partition wall may be provided between the colored layers. A material for the partition wall is not particularly limited. Examples thereof include organic materials such as a siloxane resin and a fluororesin, and inorganic particles such as a silica particle. In addition, the partition wall may be composed of a metal such as tungsten and aluminum.

In addition, in a case where a color filter is provided, it is also preferable that an infrared cut filter is provided on an optical path of the color filter. Specific examples of the infrared cut filter include the filters disclosed in WO2016/186050A, WO2016/035695A, JP6248945B, WO2019/021767A, JP2017-067963A, and JP6506529B.

The photodetector element of the embodiment of the present invention may be provided with a protective layer, an antireflection film, a lens, or the like on a light incident side of the optical filter 30. As the antireflection film, for example, a film produced from the composition described in WO2019/017280A can be used. As the lens, for example, the structure described in WO2018/092600A can be used.

The photodetector element of the embodiment of the present invention may further comprise a band-pass filter on a light incident side of the optical filter 30. The band-pass filter may be formed on the front surface of the optical filter 30, or may be formed in a member different from the optical filter 30 and provided on the optical filter 30.

Examples of the band-pass filter include a dielectric multi-layer film. Examples of the dielectric multi-layer film include those in which a plurality of layers are laminated by alternately laminating a dielectric thin film having a high refractive index (high-refractive-index material layer) and a dielectric thin film having a low refractive index (low-refractive-index material layer). The number of laminated layers of the dielectric thin film in the dielectric multi-layer film is not particularly limited, but is preferably 2 to 100 layers, more preferably 4 to 60 layers, and still more preferably 6 to 40 layers. The material that is used for forming the high-refractive-index material layer is preferably a material having a refractive index of 1.7 to 2.5. Specific examples thereof include Sb₂O₃, Sb₂S₃, Bi₂O₃, CeO₂, CeF₃, HfO₂, La₂O₃, Nd₂O₃, Pr₆O₁₁, Sc₂O₃, SiO, Ta₂O₅, TiO₂, TICl, Y₂O₃, ZnSe, ZnS, and ZrO₂. The material that is used for forming the low-refractive-index material layer is preferably a material having a refractive index of 1.2 to 1.6. Specific examples thereof include Al₂O₃, BiF₃, CaF₂, LaF₃, PbCl₂, PbF₂, LiF, MgF₂, MgO, NdF₃, SiO₂, Si₂O₃, NaF, ThO₂, ThF₄, and Na₃AlF₆. A method for forming the dielectric multi-layer film is not particularly limited, but examples thereof include ion plating, a vacuum deposition method using an ion beam or the like, a physical vapor deposition method (PVD method) such as sputtering, and a chemical vapor deposition method (CVD method). A thickness of each of the high-refractive-index material layer and the low-refractive-index material layer is preferably 0.1 λ to 0.5 λ of a wavelength λ (nm) of light to be blocked.

In the band-pass filter, a maximum value of a transmittance of light in a range of the maximal absorption wavelength of the quantum dot layer 13 ± 100 nm is preferably 60% or more, more preferably 70% or more, and still more preferably 80% or more.

The spectral characteristics in a wavelength range of 400 to 1,100 nm of the band-pass filter can be appropriately selected.

As one aspect, there may be an aspect in which a maximum value of a transmittance of light in a wavelength range of 400 to 700 nm of the band-pass filter is 30% or less. According to this aspect, it is possible to receive infrared rays having a target wavelength with less noise derived from the sunlight in the photoelectric conversion element, and it is possible to further enhance the accuracy of sensing using infrared rays.

As another aspect, there may be an aspect in which a minimum value of a transmittance of light in a wavelength range of 900 to 1,100 nm of the band-pass filter is 30% or less. According to this aspect, in a case where the infrared rays having the target wavelength is at 1,200 to 1,500 nm in the photoelectric conversion element, the light reception of the infrared rays other than the target wavelength can be suppressed and the accuracy of the sensing using the infrared rays having the target wavelength can be further enhanced.

### <Image Sensor>

The image sensor of an embodiment of the present invention includes the above-described photodetector element of the embodiment of the present invention.

Since the photodetector element of the embodiment of the present invention has excellent sensitivity to infrared rays, it can be particularly preferably used as an infrared sensor. In addition, the image sensor can be preferably used as a sensor that senses light at a wavelength of 900 to 1,700 nm, and can be more preferably used as a sensor that senses light at a wavelength of 1,300 to 1,500 nm.

In addition, the image sensor of the embodiment of the present invention can also be used as an image sensor that can simultaneously acquire a visible light image and an infrared image. In a case where the photodetector element of the embodiment of the present invention comprises a color filter, the image sensor can acquire a color visible light image and an infrared image at the same time.

### <Method for Manufacturing Photodetector Element>

A first aspect of a method for manufacturing a photodetector element of an embodiment of the present invention is a method for manufacturing a photodetector element including a photoelectric conversion element, an optical filter provided on a light incident side of the photoelectric conversion element, and an interlayer provided between the photoelectric conversion element and the optical filter, the method including:
a step of applying a composition for forming an optical filter onto the interlayer to form a composition layer for forming an optical filter, and exposing the composition layer for forming an optical filter two or more times to form an optical filter,
in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer includes at least one kind of atom selected from the group consisting of Si, Al, Zr, Sn, Zn, Ce, and Hf, or includes a paraxylene polymer.

That is, the first aspect of the method for manufacturing a photodetector element of the embodiment of the present invention is a method for manufacturing the above-described photodetector element of the first aspect, the method including the step of applying a composition for forming an optical filter onto the interlayer to form a composition layer for forming an optical filter, and exposing the composition layer for forming an optical filter two or more times to form an optical filter.

A second aspect of the method for manufacturing a photodetector element of the embodiment of the present invention is a method for manufacturing a photodetector element including a photoelectric conversion element, an optical filter provided on a light incident side of the photoelectric conversion element, and an interlayer provided between the photoelectric conversion element and the optical filter, the method including:
a step of applying a composition for forming an optical filter onto the interlayer to form a composition layer for forming an optical filter, and exposing the composition layer for forming an optical filter two or more times to form an optical filter,
in which the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer has a water vapor permeability as determined by a method in accordance with JIS K 7129 of 1 × 10⁻⁴ g/m²/day or less.

That is, the second aspect of the method for manufacturing a photodetector element of the embodiment of the present invention is a method for manufacturing the above-described photodetector element of the second aspect includes a step of applying a composition for forming an optical filter onto the interlayer to form a composition layer for forming an optical filter, and exposing the composition layer for forming an optical filter two or more times to form an optical filter.

The details of the photodetector element and the composition for forming an optical filter are as described above.

Examples of a method for applying the composition for forming an optical filter include the above-described methods.

In a case of forming the optical filter, it is also preferable to patternwise expose the composition layer for forming an optical filter and to remove the non-exposed portion of the composition layer for forming an optical filter by development, thereby forming a pattern. For example, the composition layer for forming an optical filter can be patternwise exposed using a stepper exposure machine, a scanner exposure machine, or the like through a mask having a predetermined mask pattern. As a result, the exposed portion of the composition layer for forming an optical filter can be cured.

Examples of the radiation (light) that can be used at the time of exposure include g-rays and i-rays. In addition, light (preferably light at a wavelength of 180 to 300 nm) having a wavelength of 300 nm or less can be used. Examples of the light at a wavelength of 300 nm or less include KrF-rays (wavelength: 248 nm) and ArF-rays (wavelength: 193 nm), and the KrF-rays (wavelength: 248 nm) are preferable. In addition, a long-wave light source of 300 nm or more can be used.

Moreover, during exposure, the exposure may be performed by continuous irradiation with light or may be performed by pulsed irradiation (pulse exposure). In addition, the pulse exposure is an exposing method in a mode in which irradiation with light and rest are repeated in a short cycle (for example, a millisecond level or lower) to perform exposure.

The irradiation amount (exposure amount) is, for example, preferably 0.03 to 2.5 J/cm², and more preferably 0.05 to 1.0 J/cm². The oxygen concentration during the exposure can be appropriately selected, and the exposure may also be performed, for example, in a low-oxygen atmosphere having an oxygen concentration of 19% by volume or less (for example, 15% by volume, 5% by volume, and substantially oxygen-free) or in a high-oxygen atmosphere having an oxygen concentration of more than 21% by volume (for example, 22% by volume, 30% by volume, and 50% by volume), in addition to an atmospheric air. In addition, the exposure illuminance can be appropriately set, and can be usually selected from a range of 1,000 W/m² to 100,000 W/m² (for example, 5,000 W/m², 15,000 W/m², or 35,000 W/m²). Appropriate conditions of each of the oxygen concentration and the illuminance of exposure energy may be combined, and for example, a combination of an oxygen concentration of 10% by volume and an illuminance of 10,000 W/m², a combination of an oxygen concentration of 35% by volume and an illuminance of 20,000 W/m², or the like is available.

The non-exposed portion of the composition layer for forming an optical filter can be removed by development using a developer. Examples of the developer include an organic solvent and an alkali developer, and the alkali developer is preferably used. Examples of the alkali developer include those described above.

In a case where the composition layer for forming an optical filter is exposed two or more times, the composition layer for forming an optical filter before development may be exposed two or more times, but it is preferable that the composition layer for forming an optical filter before development is subjected to first exposure and the composition layer for forming an optical filter after development is subjected to second exposure. In addition, it is also preferable that the first exposure is performed with light at a wavelength of more than 350 nm and 380 nm or less, and the second exposure is performed with light at a wavelength of 254 to 350 nm.

### Examples

Hereinafter, the present invention will be described in more detail with reference to Examples. Materials, used amounts, proportions, treatment details, treatment procedures, and the like shown in the following examples can be appropriately changed within a range not departing from the scope of the present invention. Therefore, the scope of the present invention is not limited to the specific examples described below. Ph in the structural formulae represents a phenyl group.

### <Production of Pigment Dispersion Liquid>

Materials shown in the following table were mixed, and then the mixture was mixed and dispersed for 3 hours using a beads mill (a high-pressure disperser with a pressure reducing mechanism, NANO-3000-10, manufactured by Nippon BEE Chemical Co., Ltd.) with a use of zirconia beads having a diameter of 0.3 mm, thereby producing a pigment dispersion liquid.

**[Table 1]**

| | Coloring material | | Pigment derivative | | Resin | | Solvent | |
|---|---|---|---|---|---|---|---|---|
| | Type | Parts by mass | Type | Parts by mass | Type | Parts by mass | Type | Parts by mass |
| A-1 | PR254 | 12.6 | - | - | BB-1 | 8.1 | S-1 | 73.9 |
| | PY139 | 5.4 | | | | | | |
| A-2 | PB15:6 | 14.4 | - | - | B-1 | 5.0 | S-1 | 42.7 |
| | PV23 | 3.6 | | | BB-1 | 3.1 | S-2 | 31.2 |
| B-1 | IR-1 | 5.4 | Derivative 1 | 2.1 | BB-1 | 6.0 | S-1 | 86.5 |
| B-2 | IR-2 | 5.4 | Derivative 2 | 2.1 | BB-1 | 6.0 | S-1 | 86.5 |

The materials described in the table are as follows.

### (Coloring Material)

PR254: C. I. Pigment Red 254 (red pigment)
PY139: C. I. Pigment Yellow 139 (yellow pigment)
PV23: C. I. Pigment Violet 23 (violet pigment)
PB15:6: C. I. Pigment Blue 15:6 (blue pigment)
IR-1: Compound having the following structure (pyrrolopyrrole compound, infrared absorbing coloring material)
IR-2: Compound having the following structure (pyrrolopyrrole compound, infrared absorbing coloring material)

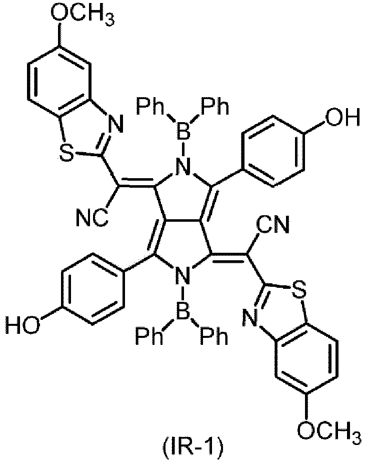

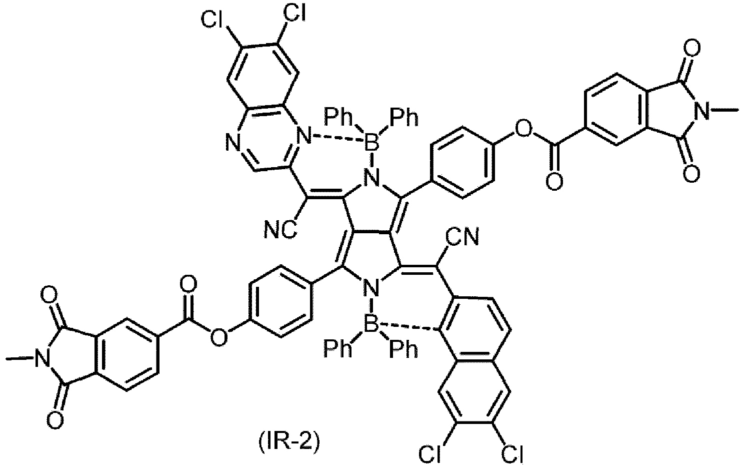

### (Pigment Derivative)

### Derivative 1: Compound having the following structure

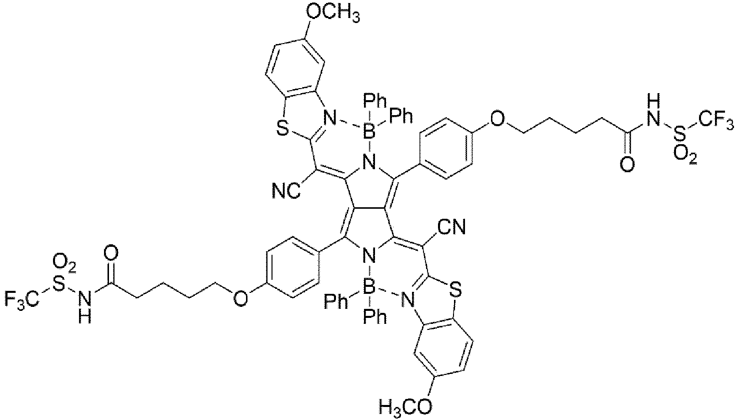

### Derivative 2: Compound having the following structure

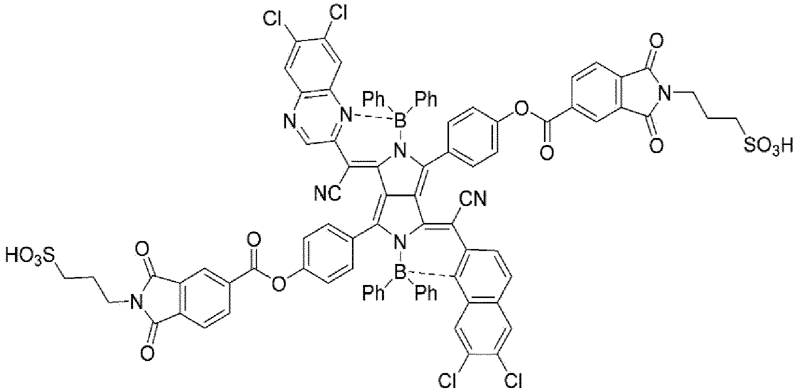

### (Resin)

B-1: Resin having the following structure (the numerical value added to the main chain is a molar ratio of the repeating units, weight-average molecular weight: 11,000)

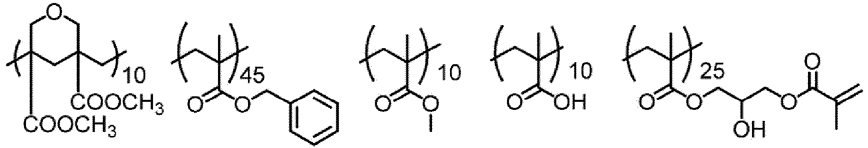

BB-1: Resin having the following structure (the numerical value added to the main chain is a molar ratio of the repeating units, and the numerical value added to the side chain is the number of repeating units, weight-average molecular weight: 20,900)

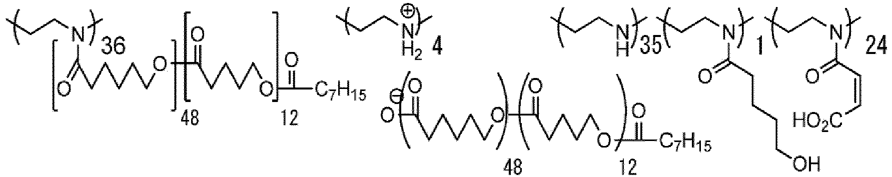

### (Solvent)

### S-1: Propylene glycol monomethyl ether acetate

### S-2: Cyclohexanone

### <Production of Composition for Forming Optical Filter>

Raw materials described in the following table were mixed to produce compositions for forming an optical filter (compositions 1 to 3). Furthermore, for the pigment dispersion liquids, the ratios were adjusted so that the total amount was the value in parts by mass shown in the table and the spectral characteristics of the obtained optical filter satisfied the spectral characteristics shown in the table described below.

**[Table 2]**

| | Pigment dispersion liquid | | Coloring material | | Resin | | Polymerizable compound | | Photopolymerizati on initiator | | Additive | | Solvent | |
|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass |
| Composition 1 | A-1 | 74.9 | IRD-1 | 3.8 | B-1 | 3.0 | M-1 | 1.2 | I-1 | 0.6 | H-1 | 0.2 | S-3 | 14.8 |
| | A-2 | | | | | | | | | | | | | |
| | B-1 | | | | | | M-2 | 1.2 | I-2 | 0.3 | | | | |
| | B-2 | | | | | | | | | | | | | |
| Composition 2 | A-1 | 41.6 | - | - | B-1 | 7.0 | M-1 | 2.8 | I-1 | 1.4 | H-1 | 0.2 | S-1 | 30.0 |
| | A-2 | | | | | | M-2 | 2.8 | I-2 | 0.7 | | | S-3 | 13.5 |
| | B-1 | | | | | | | | | | | | | |
| Composition 3 | A-1 | 74.9 | IRD-1 | 4.0 | B-1 | 3.0 | M-1 | 1.0 | I-1 | 1.2 | H-1 | 0.2 | S-3 | 13.4 |
| | A-2 | | | | | | | | | | | | | |
| | B-1 | | | | | | M-2 | 1.4 | I-2 | 0.9 | | | | |
| | B-2 | | | | | | | | | | | | | |

The materials described in the table are as follows.

### (Pigment Dispersion Liquid)

A-1, A-2, B-1, and B-2: Pigment dispersion liquids A-1, A-2, B-1, and B-2

### (Coloring Material)

IRD-1: Compound having the following structure (imminium compound, infrared absorbing coloring material)

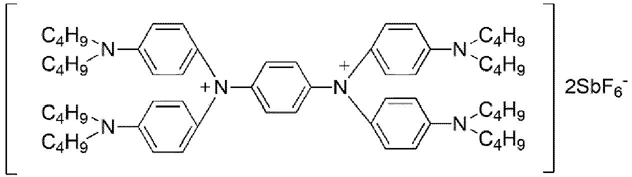

### (Resin)

### B-1: Resin B-1 described above

### (Polymerizable Compound)

M-1: Mixture of compounds having the following structures (mixture in which a molar ratio of a compound on the left side (hexafunctional (meth)acrylate compound) to a compound on the right side (pentafuctional (meth)acrylate compound) is 7:3)

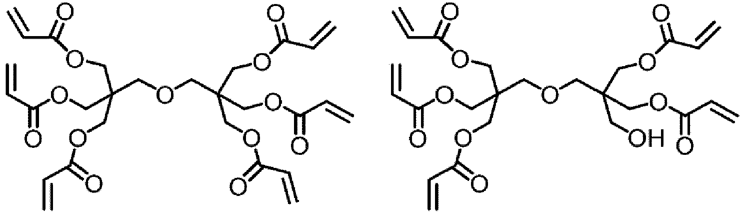

M-2: Compound having the following structure

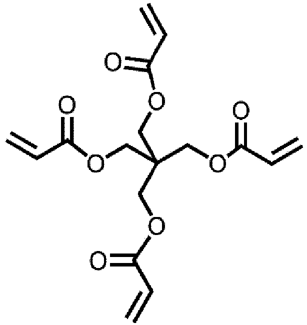

### (Photopolymerization Initiator)

I-1 and I-2: Compounds having the following structures

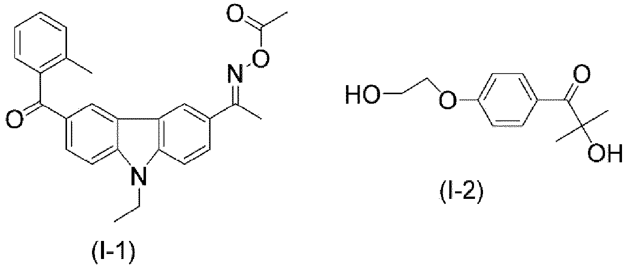

### (Additive)

H-1: 3-(Trimethoxysilyl)propyl methacrylate

### (Solvent)

S-1: Propylene glycol monomethyl ether acetate
S-3: Cyclopentylmethyl ether

### <Manufacture of Photodetector Element>

A photodetector element shown in Fig. 1 was manufactured. The photoelectric conversion element, the interlayer, and the optical filter are as follows. Furthermore, ITO in the following tables refers to indium tin oxide. In addition, a film thickness ratio 1 in the following table is a ratio of the thickness of the interlayer to the thickness of the quantum dot layer (thickness of interlayer/thickness of quantum dot layer), and a film thickness ratio 2 is a ratio of the thickness of the optical filter to the thickness of the quantum dot layer (thickness of optical filter/thickness of quantum dot layer).

The interlayer was formed by forming a film on a surface of the first electrode of the photoelectric conversion element with the material shown in the following table by a chemical vapor deposition method (CVD) or an atomic layer deposition method (ALD). In Example 9, a ZrO₂ film was formed on a surface of the first electrode by the atomic layer deposition method (ALD), and then an SiO₂ film was formed on the ZrO₂ film by the atomic layer deposition method (ALD). In Example 10, SiON was formed into a film on a surface of the first electrode by the atomic layer deposition method (ALD), and then SiO₂ was formed into a film on the SiON film by the atomic layer deposition method (ALD).

In addition, the water vapor permeability of the interlayer was measured by a method in accordance with JIS K 7129. The water vapor permeability of the interlayer in each of Examples was 1 × 10⁻⁴ g/m²/day or less.

For the optical filter, the composition for forming an optical filter was applied onto a surface of the interlayer by spin coating, and the coating film was irradiated with light at a wavelength of 365 nm at an exposure amount of 50 to 1,700 mJ/cm² through a mask having an island pattern with a side length of 2.0 µm, using an i-line stepper exposure device FPA-i5+ (manufactured by Canon Inc.) to perform a first exposure. Thereafter, the film was irradiated with an exposure amount of 10,000 mJ/cm² using an ultraviolet photoresist curing device (MMA-802-HC-552, manufactured by Ushio Inc.) to carry out a second exposure for the formation.

**[Table 3]**

| | Photoelectric conversion element | | | | | | | |
|---|---|---|---|---|---|---|---|---|
| | Quantum dot layer | | | | First electrode | | Second electrode | |
| | Quantum dot | Ligand | Film thickness (nm) | Maximal absorption wavelength (nm) of quantum dot layer | Material | Film thickness (nm) | Material | Film thickness (nm) |
| Example 1 | PbS | 3-Mercaptopropionic acid | 400 | 1,300 to 1,500 | ITO | 100 | Au | 100 |
| Example 2 | PbS | 3-Mercaptopropionic acid | 400 | 1,300 to 1,500 | ITO | 100 | Au | 100 |
| Example 3 | PbS | 3-Mercaptopropionic acid | 400 | 1,300 to 1,500 | ITO | 100 | Au | 100 |
| Example 4 | PbS | 3-Mercaptopropionic acid | 400 | 1,300 to 1,500 | ITO | 100 | Au | 100 |
| Example 5 | PbS | 3-Mercaptopropionic acid | 400 | 1,300 to 1,500 | ITO | 100 | Au | 100 |
| Example 6 | PbS | 3-Mercaptopropionic acid | 400 | 1,300 to 1,500 | ITO | 100 | Au | 100 |
| Example 7 | PbS | 3-Mercaptopropionic acid | 400 | 1,300 to 1,500 | ITO | 100 | Au | 100 |
| Example 8 | PbS | 3-Mercaptopropionic acid | 400 | 1,300 to 1,500 | ITO | 100 | Au | 100 |
| Example 9 | PbS | 3-Mercaptopropionic acid | 400 | 1,300 to 1,500 | ITO | 100 | Au | 100 |
| Example 10 | PbS | 3-Mercaptopropionic acid | 400 | 1,300 to 1,500 | ITO | 100 | Au | 100 |
| Example 11 | PbS | 3-Mercaptopropionic acid | 400 | 900 to 1,000 | ITO | 100 | Au | 100 |
| Example 12 | PbS | 3-Mercaptopropionic acid | 400 | 1,500 to 1,700 | ITO | 100 | Au | 100 |
| Example 13 | PbS | 3-Mercaptopropionic acid | 200 | 1,300 to 1,500 | ITO | 100 | Au | 100 |
| Example 14 | PbS | 3-Mercaptopropionic acid | 700 | 1,300 to 1,500 | ITO | 100 | Au | 100 |
| Example 15 | PbS | 3-Mercaptopropionic acid | 700 | 1,300 to 1,500 | ITO | 100 | Au | 100 |
| Example 16 | PbS | 3-Mercaptopropionic acid | 700 | 1,300 to 1,500 | ITO | 100 | Au | 100 |
| Example 17 | InP | 3-Mercaptopropionic acid | 400 | 1,300 to 1,500 | ITO | 100 | Au | 100 |
| Example 18 | InAs | 3-Mercaptopropionic acid | 400 | 900 to 1,000 | ITO | 100 | Au | 100 |
| Example 19 | InAs | 3-Mercaptopropionic acid | 400 | 1,300 to 1,500 | ITO | 100 | Au | 100 |
| Example 20 | InSb | 3-Mercaptopropionic acid | 400 | 900 to 1,000 | ITO | 100 | Au | 100 |
| Example 21 | InSb | 3-Mercaptopropionic acid | 400 | 1,300 to 1,500 | ITO | 100 | Au | 100 |
| Example 22 | InSb | InBr₃ | 400 | 1,300 to 1,500 | ITO | 100 | Au | 100 |
| Example 23 | GeO₂ | 3-Mercaptopropionic acid | 400 | 1,300 to 1,500 | ITO | 100 | Au | 100 |
| Example 24 | Ge | 3-Mercaptopropionic acid | 400 | 1,300 to 1,500 | ITO | 100 | Au | 100 |
| Example 25 | CIGS | 3-Mercaptopropionic acid | 400 | 1,300 to 1,500 | ITO | 100 | Au | 100 |
| Example 26 | Lead perovskite | 3-Mercaptopropionic acid | 400 | 1,300 to 1,500 | ITO | 100 | Au | 100 |
| Example 27 | AgBiS₂ | 3-Mercaptopropionic acid | 400 | 1,300 to 1,500 | ITO | 100 | Au | 100 |
| Comparative Example 1 | PbS | 3-Mercaptopropionic acid | 400 | 1,300 to 1,500 | ITO | 100 | Au | 100 |

**[Table 4]**

| | Interlayer | | | Optical filter | | Film thickness ratio 1 | Film thickness ratio 2 |
|---|---|---|---|---|---|---|---|
| | Material | Film forming method | Film thickness (nm) | Type | Film thickness (nm) | | |
| Example 1 | SiO₂ | ALD | 20 | Optical filter 1 | 1,000 | 0.05 | 2.50 |
| Example 2 | SiON | CVD | 400 | Optical filter 1 | 1,000 | 1.00 | 2.50 |
| Example 3 | SiON | ALD | 20 | Optical filter 1 | 1,000 | 0.05 | 2.50 |
| Example 4 | SiN | ALD | 20 | Optical filter 1 | 1,000 | 0.05 | 2.50 |
| Example 5 | Zr₂O₃ | ALD | 20 | Optical filter 1 | 1,000 | 0.05 | 2.50 |
| Example 6 | ZnO | ALD | 20 | Optical filter 1 | 1,000 | 0.05 | 2.50 |
| Example 7 | CeO₂ | ALD | 20 | Optical filter 1 | 1,000 | 0.05 | 2.50 |
| Example 8 | HfO₂ | ALD | 20 | Optical filter 1 | 1,000 | 0.05 | 2.50 |
| Example 9 | SiO₂/ZrO₂ | ALD/ALD | 10/10 | Optical filter 1 | 1,000 | 0.05 | 2.50 |
| Example 10 | SiO₂/SiON | ALD/ALD | 100/100 | Optical filter 1 | 1,000 | 0.50 | 2.50 |
| Example 11 | SiO₂ | ALD | 20 | Optical filter 2 | 1,000 | 0.05 | 2.50 |
| Example 12 | SiO₂ | ALD | 20 | Optical filter 3 | 1,000 | 0.05 | 2.50 |
| Example 13 | SiO₂ | ALD | 20 | Optical filter 1 | 1,000 | 0.10 | 5.00 |
| Example 14 | SiO₂ | ALD | 20 | Optical filter 1 | 1,000 | 0.03 | 1.43 |
| Example 15 | SiO₂ | ALD | 7 | Optical filter 1 | 1,000 | 0.01 | 1.43 |
| Example 16 | Paraxylene polymer | CVD | 1,000 | Optical filter 1 | 1,000 | 1.43 | 1.43 |
| Example 17 | SiO₂ | ALD | 20 | Optical filter 1 | 1,000 | 0.05 | 2.50 |
| Example 18 | SiO₂ | ALD | 20 | Optical filter 2 | 1,000 | 0.05 | 2.50 |
| Example 19 | SiO₂ | ALD | 20 | Optical filter 1 | 1,000 | 0.05 | 2.50 |
| Example 20 | SiO₂ | ALD | 20 | Optical filter 2 | 1,000 | 0.05 | 2.50 |
| Example 21 | SiO₂ | ALD | 20 | Optical filter 1 | 1,000 | 0.05 | 2.50 |
| Example 22 | SiO₂ | ALD | 20 | Optical filter 1 | 1,000 | 0.05 | 2.50 |
| Example 23 | SiO₂ | ALD | 20 | Optical filter 1 | 1,000 | 0.05 | 2.50 |
| Example 24 | SiO₂ | ALD | 20 | Optical filter 1 | 1,000 | 0.05 | 2.50 |
| Example 25 | SiO₂ | ALD | 20 | Optical filter 1 | 1,000 | 0.05 | 2.50 |
| Example 26 | SiO₂ | ALD | 20 | Optical filter 1 | 1,000 | 0.05 | 2.50 |
| Example 27 | SiO₂ | ALD | 20 | Optical filter 1 | 1,000 | 0.05 | 2.50 |
| Comparative Example 1 | None | - | - | Optical filter 1 | 1,000 | - | 2.50 |

The optical filter 1 is an optical filter formed of the composition 1 as a composition for forming an optical filter, and has spectral characteristics in which a maximum value of a transmittance of light in a wavelength range of 400 to 1,200 nm is 20% or less, and a maximum value of a transmittance of light in a wavelength range of 1,300 to 1,500 nm is 60% or more.

The optical filter 2 is an optical filter formed of the composition 2 as a composition for forming an optical filter, and has spectral characteristics in which a maximum value of a transmittance of light in a wavelength range of 400 to 700 nm is 20% or less, and a maximum value of a transmittance of light in a wavelength range of 900 to 1,000 nm is 60% or more.

The optical filter 3 is an optical filter formed of a composition 3 as the composition for forming an optical filter, and has spectral characteristics in which a maximum value of a transmittance of light in a wavelength range of 400 to 1,200 nm is 20% or less, and a maximum value of a transmittance of light in a wavelength range of 1,500 to 1,700 nm is 60% or more.

### <Evaluation of Dark Current and External Quantum Efficiency>

A dark current and an external quantum efficiency of the photodetector elements before and after the formation of the optical filter were measured using a semiconductor parameter analyzer (C4156, manufactured by Agilent Technologies, Inc.), a degree of fluctuation in dark current and a degree of fluctuation in external quantum efficiency were calculated, and the dark current and the external quantum efficiency were evaluated according to the following standard.

Degree of fluctuation in dark current = Dark current of photodetector element after formation of optical filter/Dark current of photodetector element before formation of optical filter

Degree of fluctuation in external quantum efficiency = External quantum efficiency of photodetector element after formation of optical filter/External quantum efficiency of photodetector element before formation of optical filter

### - Evaluation Standard of Dark Current -

A: The degree of fluctuation in dark current is 1 or more and 5 or less.
B: The degree of fluctuation in dark current is more than 5 and 10 or less.
C: The degree of fluctuation in dark current is more than 10.

### - Evaluation Standard of External Quantum Efficiency -

A: The degree of fluctuation in external quantum efficiency is more than 0.8 and 1 or less.
B: The degree of fluctuation in external quantum efficiency is more than 0.5 and 0.8 or less.
C: The degree of fluctuation in external quantum efficiency is 0.5 or less.

**[Table 5]**

| | External quantum efficiency | Dark current |
|---|---|---|
| Example 1 | A | A |
| Example 2 | A | B |
| Example 3 | A | A |
| Example 4 | A | A |
| Example 5 | A | A |
| Example 6 | A | A |
| Example 7 | A | A |
| Example 8 | A | A |
| Example 9 | A | A |
| Example 10 | A | A |
| Example 11 | A | A |
| Example 12 | A | A |
| Example 13 | A | A |
| Example 14 | A | A |
| Example 15 | B | A |
| Example 16 | B | B |
| Example 17 | A | A |
| Example 18 | A | A |
| Example 19 | A | A |
| Example 20 | A | A |
| Example 21 | A | A |
| Example 22 | A | A |
| Example 23 | A | A |
| Example 24 | A | A |
| Example 25 | A | A |
| Example 26 | A | A |
| Example 27 | A | A |
| Comparative Example 1 | C | C |

As shown in the tables above, the dark current could be suppressed with the photodetector elements of Examples.

### Explanation of References

1: photodetector element
10: photoelectric conversion element
11: first electrode
12: second electrode
13: quantum dot layer
20: interlayer
30: optical filter

## Claims

1. A photodetector element comprising:
a photoelectric conversion element;
an optical filter provided on a light incident side of the photoelectric conversion element; and
an interlayer provided between the photoelectric conversion element and the optical filter,
wherein the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer includes at least one kind of atom selected from the group consisting of Si, Al, Zr, Sn, Zn, Ce, and Hf, or includes a paraxylene polymer.

2. A photodetector element comprising:
a photoelectric conversion element;
an optical filter provided on a light incident side of the photoelectric conversion element; and
an interlayer provided between the photoelectric conversion element and the optical filter,
wherein the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer has a water vapor permeability as determined by a method in accordance with JIS K 7129 of 1 × 10⁻⁴ g/m²/day or less.

3. The photodetector element according to claim 1 or 2,
wherein a ratio of a thickness of the interlayer to a thickness of the quantum dot layer is 0.01 to 1.

4. The photodetector element according to claim 1 or 2,
wherein the interlayer includes a film formed with at least one selected from the group consisting of silicon oxide, silicon oxynitride, silicon nitride, zirconium oxide, zinc oxide, cerium oxide, aluminum oxide, and hafnium oxide by an atomic layer deposition method.

5. The photodetector element according to claim 1 or 2,
wherein a ratio of a thickness of the optical filter to a thickness of the quantum dot layer is 0.1 to 100.

6. The photodetector element according to claim 1 or 2,
wherein the quantum dot layer has a higher absorbance at a wavelength of 550 nm than that at a wavelength of 1,450 nm.

7. The photodetector element according to claim 1 or 2,
wherein the quantum dot layer includes quantum dots including at least one kind of atom selected from the group consisting of Ga, As, Se, In, Sb, Te, and Bi.

8. The photodetector element according to claim 1 or 2,
wherein the quantum dot layer includes the quantum dots and ligands coordinated to the quantum dots, and
the ligands include an inorganic ligand including a halogen atom.

9. The photodetector element according to claim 1 or 2,
wherein a thickness of the quantum dot layer is 200 to 700 nm.

10. The photodetector element according to claim 1 or 2,
wherein the maximal absorption wavelength of the quantum dot layer is present in a wavelength range of 1,300 to 1,500 nm.

11. The photodetector element according to claim 1 or 2,
wherein the first electrode includes indium tin oxide.

12. An image sensor comprising:
the photodetector element according to claim 1 or 2.

13. The image sensor according to claim 12,
wherein the image sensor is an infrared sensor.

14. A method for manufacturing a photodetector element including a photoelectric conversion element, an optical filter provided on a light incident side of the photoelectric conversion element, and an interlayer provided between the photoelectric conversion element and the optical filter, the method comprising:
a step of applying a composition for forming an optical filter onto the interlayer to form a composition layer for forming an optical filter, and exposing the composition layer for forming an optical filter two or more times to form the optical filter,
wherein the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer includes at least one kind of atom selected from the group consisting of Si, Al, Zr, Sn, Zn, Ce, and Hf, or includes a paraxylene polymer.

15. A method for manufacturing a photodetector element including a photoelectric conversion element, an optical filter provided on a light incident side of the photoelectric conversion element, and an interlayer provided between the photoelectric conversion element and the optical filter, the method comprising:
a step of applying a composition for forming an optical filter onto the interlayer to form a composition layer for forming an optical filter, and exposing the composition layer for forming an optical filter two or more times to form the optical filter,
wherein the photoelectric conversion element has a quantum dot layer including quantum dots and having a maximal absorption wavelength of an absorbance present in a wavelength range of 900 to 1,700 nm, a first electrode provided on a light incident side of the quantum dot layer, and a second electrode provided on a surface of the quantum dot layer on a side opposite to a side on which the first electrode is provided,
in the optical filter, a maximum value of a transmittance of light in a wavelength range of 400 to 700 nm is 20% or less, and a maximum value of a transmittance of light in a range of the maximal absorption wavelength of the quantum dot layer ± 100 nm is 60% or more, and
the interlayer has a water vapor permeability as determined by a method in accordance with JIS K 7129 of 1 × 10⁻⁴ g/m²/day or less.
